# EUROPEAN PATENT APPLICATION

(11) **EP 4 344 176 A1**
(43) Date of publication of application: **27.03.2024**
(21) Application number: 23754988.6
(22) Date of filing: 08.08.2023
(51) Int. Cl.: H04M 1/02, H05K 1/14, G06F 1/16, H01Q 1/24, H05K 1/02

(54) **FOLDABLE ELECTRONIC DEVICE COMPRISING FLEXIBLE PRINTED CIRCUIT BOARD**

(30) Priority: 08.08.2022 KR 20220098675; 10.08.2022 KR 20220100201
(71) Applicant: Samsung Electronics Co., Ltd., Suwon-si, Gyeonggi-do 16677 (KR)
(72) Inventor: CHO, Sujin, Suwon-si, Gyeonggi-do 16677 (KR); CHUN, Woosung, Suwon-si, Gyeonggi-do 16677 (KR); JANG, Gyeyun, Suwon-si, Gyeonggi-do 16677 (KR); AN, Jungchul, Suwon-si, Gyeonggi-do 16677 (KR); HONG, Hyunju, Suwon-si, Gyeonggi-do 16677 (KR)
(74) Representative: Gulde & Partner
(86) International application number: PCT/KR2023/011677
(87) International publication number: WO 2024/035076

(57) **Abstract**

According to an exemplary embodiment of the disclosure, a foldable electronic device may include a foldable housing, a flexible display module, a first flexible printed circuit board, and a first non-conductive member. The foldable housing may include a first housing, a second housing, and a hinge part configured to connect the first housing and the second housing. The flexible display module may include a first display area disposed in the first housing, a second display area disposed in the second housing, and a third display area positioned between the first display area and the second display area to correspond to the hinge part. The first flexible printed circuit board may be accommodated in the first housing and may include a first surface facing the first display area and a second surface oriented in a direction opposite to the first surface. The first non-conductive member may be disposed between the first surface of the first flexible printed circuit board and the first housing. The first housing may include a first lateral part connected to the hinge part and including a metal material. The second housing may include a second lateral part connected to the hinge part. In a view from above the second surface, the first flexible printed circuit board may include a first area configured to face and overlap the first lateral part. The first non-conductive member may be disposed between the first area and the first lateral part.

## Description

### [Technical Field]

The disclosure relates to a foldable electronic device including a flexible printed circuit board.

### [Background Art]

There is a foldable electronic device having a screen (or a display) that can be folded. The screen of the electronic device may be folded to increase the portability thereof, and the display may be unfolded when the same is used, thereby providing a large screen.

The above-described information may be provided as a related art intended to help understanding of the disclosure. No claim or determination is raised in connection with whether any of the above description is applicable as a prior rat related to the disclosure.

### [Disclosure of Invention]

### [Technical Problem]

There is difficulty in disposing electric elements in a limited space inside a foldable electronic device while reducing electromagnetic interference (EMI) between the electric elements. Slimness of foldable electronic devices exacerbates such problems. A foldable electronic device may include a flexible printed circuit board configured to transfer radio frequency (RF) signals. It may be necessary to dispose the flexible printed circuit board so as to reduce the electromagnetic influence (or electromagnetic interference) (for example, RF performance degradation, communication performance degradation, or antenna performance degradation) exerted on the flexible printed circuit board by other electric elements inside the foldable electronic device.

Exemplary embodiments of the disclosure provide a foldable electronic device including a flexible printed circuit board, wherein the flexible printed circuit board can be efficiently disposed in a limited space inside the foldable electronic device.

Exemplary embodiments of the disclosure may provide a foldable electronic device including a flexible printed circuit board, which can reduce the electromagnetic influence (or electromagnetic interference) (for example, RF performance degradation, communication performance degradation, or antenna performance degradation) exerted on the flexible printed circuit board by other electric elements inside the foldable electronic device.

Technical problems to be solved by the disclosure are not limited to the above-mentioned technical problems, and other technical problems not mentioned herein will be clearly understood from the following description by those skilled in the art to which the disclosure pertains.

### [Solution to Problem]

According to an exemplary embodiment of the disclosure, a foldable electronic device includes a foldable housing, a flexible display module, a first flexible printed circuit board, and a first non-conductive member. The foldable housing includes a first housing, a second housing, and a hinge part configured to connect the first housing and the second housing. The flexible display module includes a first display area disposed in the first housing, a second display area disposed in the second housing, and a third display area positioned between the first display area and the second display area to correspond to the hinge part. The first flexible printed circuit board is accommodated in the first housing and may include a first surface facing the first display area and a second surface oriented in a direction opposite to the first surface. The first non-conductive member is disposed between the first surface of the first flexible printed circuit board and the first housing. The first housing includes a first lateral part connected to the hinge part and including a metal material. The second housing includes a second lateral part connected to the hinge part. In a view from above the second surface, the first flexible printed circuit board includes a first area configured to face and overlap the first lateral part. The first non-conductive member is disposed between the first area and the first lateral part.

### [Advantageous Effects of Invention]

A foldable electronic device including a flexible printed circuit board according to an exemplary embodiment of the disclosure is advantageous in that the flexible printed circuit board is disposed by utilizing a part connected to a hinge portion, among a first housing, in a limited space inside the foldable electronic device, thereby improving space efficiency, and the electromagnetic influence exerted on the flexible printed circuit board by the part connected to the hinge portion among the first housing, thereby securing the integrity of signals transferred through the flexible printed circuit board.

Various other advantageous effects obtainable or predictable from various embodiments of the disclosure may be disclosed explicitly or implicitly through the detailed description of embodiments of the disclosure.

### [Brief Description of Drawings]

The above and other aspects, features, and advantages of specific embodiments of the disclosure will become more apparent from the following detailed descriptions taken in conjunction with the accompanying drawings.
FIG. 1 is a block diagram of an electronic device in a network environment according to an embodiment of the disclosure.
FIG. 2 shows views of a foldable electronic device in an unfolded state according to an embodiment of the disclosure.
FIG. 3 shows views of a foldable electronic device in a folded state according to an embodiment of the disclosure.
FIG. 4 is an exploded perspective view of a foldable electronic device in an unfolded state according to an embodiment of the disclosure.
FIGS. 5 and 6 are views showing a foldable housing in an unfolded state according to an embodiment of the disclosure.
FIG. 7 is a view showing a hinge part according to an embodiment of the disclosure.
FIG. 8 is a view showing a hinge part, a third flexible printed circuit board, and a fourth flexible printed circuit board according to an embodiment of the disclosure.
FIG. 9 is a view showing a first hinge module, a second hinge module, a third hinge module, a hinge housing, and a third printed circuit board according to an embodiment of the disclosure.
FIG. 10 is a view showing a hinge part, a first printed circuit board, a second printed circuit board, a third printed circuit board, a first battery, a first flexible printed circuit board, a third flexible printed circuit board, and a fourth flexible printed circuit board according to an embodiment of the disclosure.
FIG. 11 shows a view of a first flexible printed circuit board, a cross-sectional view of the first flexible printed circuit board cut along line B-B', and a cross-sectional view of the first flexible printed circuit board cut along line C-C', according to an embodiment of the disclosure.
FIG. 12 shows a view of a part of a foldable electronic device in an unfolded state and a cross-sectional view of the foldable electronic device cut along line D-D', according to an embodiment of the disclosure.
FIG. 13 shows a view of a part of a foldable electronic device, a cross-sectional view of the foldable electronic device cut along line E-E', a cross-sectional view of the foldable electronic device cut along line F-F', and a cross-sectional view of the foldable electronic device cut along line G-G', according to an embodiment of the disclosure.
FIG. 14 is a view showing a part of a foldable electronic device according to an embodiment of the disclosure.
FIG. 15 is a view showing a first battery and a first flexible printed circuit board according to an embodiment of the disclosure.
FIG. 16 is a view showing a first antenna structure and a first flexible printed circuit board according to an embodiment of the disclosure.
FIG. 17 is a cross-sectional view showing a foldable electronic device cut along line H-H' in FIG. 14 according to an embodiment of the disclosure.
FIG. 18 shows a view of a first flexible printed circuit board and a cross-sectional view of the first flexible printed circuit board cut along line K-K', according to an embodiment of the disclosure.
FIG. 19 is a view showing a first flexible printed circuit board according to an embodiment of the disclosure.
FIG. 20 is a cross-sectional view showing a foldable electronic device cut along line I-I' in FIG. 14 according to an embodiment of the disclosure.
FIG. 21 is a perspective view showing a part of a foldable electronic device according to an embodiment of the disclosure.
FIG. 22 is a cross-sectional view showing a foldable electronic device cut along line J-J' in FIG. 14 according to an embodiment of the disclosure.

### [Mode for the Invention]

Hereinafter, various example embodiments of the disclosure disclosed herein will be described in greater detail with reference to the accompanying drawings.

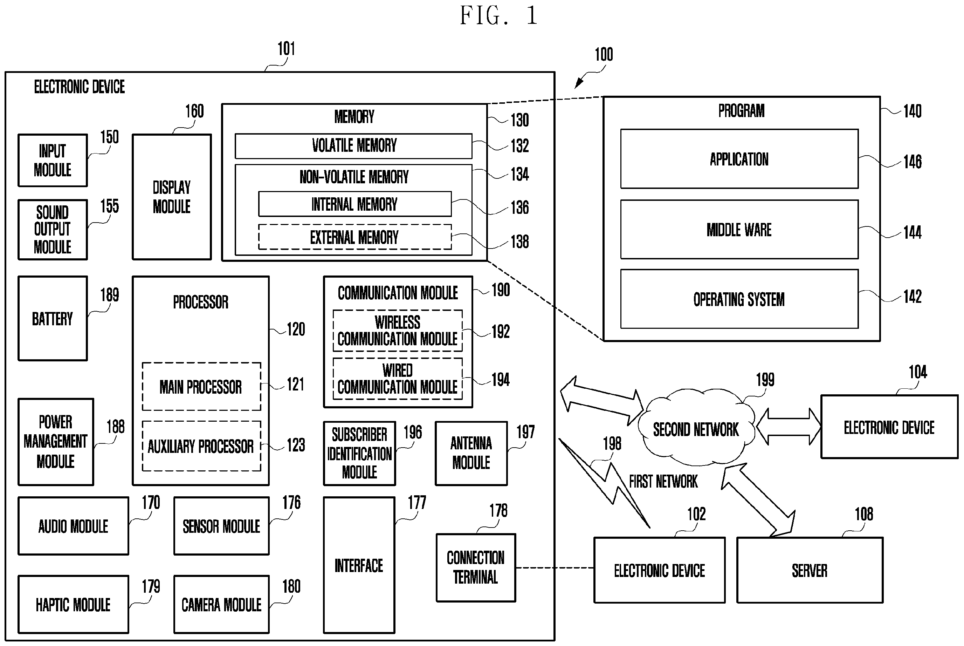

FIG. 1 is a block diagram of an electronic device 101 in a network environment 100 according to an embodiment of the disclosure.

Referring to FIG. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). The electronic device 101 may communicate with the external electronic device 104 via the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In various embodiments of the disclosure, at least one (e.g., the connection terminal 178) of the components may be omitted from the electronic device 101, or one or more other components may be added in the electronic device 101. In various embodiments of the disclosure, some of the components may be implemented as single integrated circuitry. For example, the sensor module 176, the camera module 180, or the antenna module 197 may be implemented as embedded in single component (e.g., the display module 160).

The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in a volatile memory 132, process the command or the data stored in the volatile memory 132, and store resulting data in a non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). The auxiliary processor 123 (e.g., an ISP or a CP) may be implemented as part of another component (e.g., the camera module 180 or the communication module 190) functionally related to the auxiliary processor 123. According to an embodiment of the disclosure, the auxiliary processor 123 (e.g., a neural network processing device) may include a hardware structure specified for processing an artificial intelligence model. The artificial intelligence model may be created through machine learning. Such learning may be performed, for example, in the electronic device 101 itself on which the artificial intelligence model is performed, or may be performed through a separate server (e.g., the server 108). The learning algorithms may include, for example, supervised learning, unsupervised learning, semi-supervised learning, or reinforcement learning, but is not limited thereto. The artificial intelligence model may include a plurality of artificial neural network layers. The artificial neural network may be any of a deep neural network (DNN), a convolutional neural network (CNN), a recurrent neural network (RNN), a restricted Boltzmann machine (RBM), a deep belief network (DBN), a bidirectional recurrent DNN (BRDNN), a deep Q-network, or a combination of two or more of the above-mentioned networks, but is not limited the above-mentioned examples. In addition to the hardware structure, the artificial intelligence model may additionally or alternatively include a software structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 and/or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record, and the receiver may be used for incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include touch circuitry (e.g., a touch sensor) adapted to detect a touch, or sensor circuitry (e.g., a pressure sensor) adapted to measure the intensity of force incurred by the touch.

The audio module 170 may convert a sound into an electrical signal and vice versa. The audio module 170 may obtain the sound via the input module 150, or output the sound via the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. The interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the external electronic device 102). The connecting terminal 178 may include, for example, an HDMI connector, a USB connector, an SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, ISPs, or flashes.

The power management module 188 may manage power supplied to or consumed by the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more CPs that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BLUETOOTH, wireless-fidelity (Wi-Fi) direct, or IR data association (IrDA)) or the second network 199 (e.g., a long-range communication network, such as a legacy cellular network, a 5th generation (5G) network, a next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4th generation (4G) network, and next-generation communication technology, e.g., new radio (NR) access technology. The NR access technology may support high-speed transmission of high-capacity data (i.e., enhanced mobile broadband (eMBB)), minimization of terminal power and connection of multiple terminals (massive machine type communications (mMTC)), or high reliability and low latency (ultra-reliable and low-latency communications (URLLC)). The wireless communication module 192 may support a high-frequency band (e.g., a mmWave band) to achieve, for example, a high data transmission rate. The wireless communication module 192 may support various technologies for securing performance in a high-frequency band, such as beamforming, massive multiple-input and multiple-output (MIMO), full-dimensional MIMO (FD-MIMO), array antenna, analog beam-forming, or large-scale antenna. The wireless communication module 192 may support various requirements specified in the electronic device 101, an external electronic device (e.g., external the electronic device 104), or a network system (e.g., the second network 199). According to an embodiment of the disclosure, the wireless communication module 192 may support a peak data rate for implementing eMBB (e.g., 20Gbps or more), loss coverage for implementing mMTC (e.g., 164dB or less), or U-plane latency for realizing URLLC (e.g., 0.5ms or less for each of downlink (DL) and uplink (UL) or 1ms or less for round trip).

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. Another component (e.g., a radio frequency integrated circuit (RFIC)) other than the radiating element may be additionally formed as part of the antenna module 197.

According to various embodiments of the disclosure, the antenna module 197 may form a mmWave antenna module. According to an embodiment of the disclosure, the mmWave antenna module may include a PCB, an RFIC that is disposed on or adjacent to a first surface (e.g., the bottom surface) of the PCB and is capable of supporting a predetermined high-frequency band (e.g., a mmWave band), and a plurality of antennas (e.g., array antennas) that is disposed on or adjacent to a second surface (e.g., the top surface or the side surface) of the PCB and is capable of transmitting or receiving a signal of the predetermined high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

Commands or data may be transmitted or received between the electronic device 101 and the external electronic device 104 via the server 108 coupled with the second network 199. Each of the external electronic devices 102 or 104 may be a device of a same type as, or a different type, from the electronic device 101. All or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide an ultra-low delay service using, for example, distributed computing or MEC. In another embodiment of the disclosure, the external electronic device 104 may include an internet of things (IoT) device. The server 108 may be an intelligent server using machine learning and/or neural networks. According to an embodiment of the disclosure, the external electronic device 104 or the server 108 may be included in the second network 199. The electronic device 101 may be applied to an intelligent service (e.g., smart home, smart city, smart car, or healthcare) based on 5G communication technology or loT-related technology.

An electronic device according to an embodiment of the disclosure may be one of various types of electronic devices. The electronic devices may include a portable communication device (e.g., a smartphone), a computer device, a portable multimedia device, a portable medical device, a camera, a wearable device, or a home appliance. However, the electronic device is not limited to any of those described above.

Various embodiments of the disclosure and the terms used herein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1 st" and "2nd," or "first" and "second" may be used to simply distinguish a corresponding component from another, and does not limit the components in other aspect (e.g., importance or order). If an element (e.g., a first element) is referred to, with or without the term "operatively" or "communicatively," as "coupled with," "coupled to," "connected with," or "connected to" another element (e.g., a second element), the element may be coupled with the other element directly (e.g., wiredly), wirelessly, or via a third element.

The term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment of the disclosure, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PLAYSTORETM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each component (e.g., a module or a program) of the above-described components may include a single entity or multiple entities. One or more of the above-described components may be omitted, or one or more other components may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration. Operations performed by the module, the program, or another component may be carried out sequentially, in parallel, repeatedly, or heuristically, or one or more of the operations may be executed in a different order or omitted, or one or more other operations may be added.

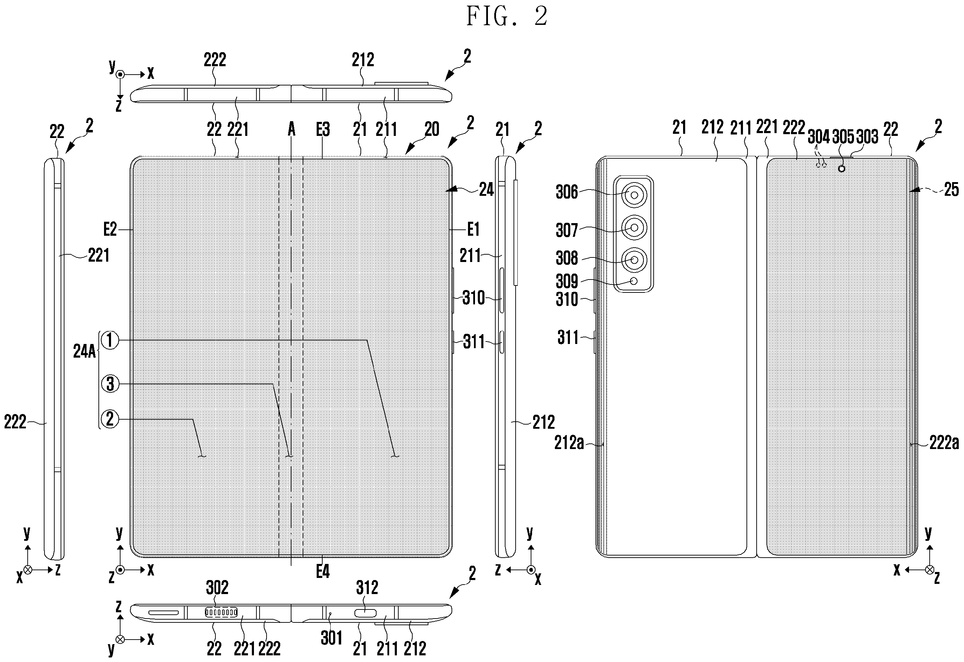

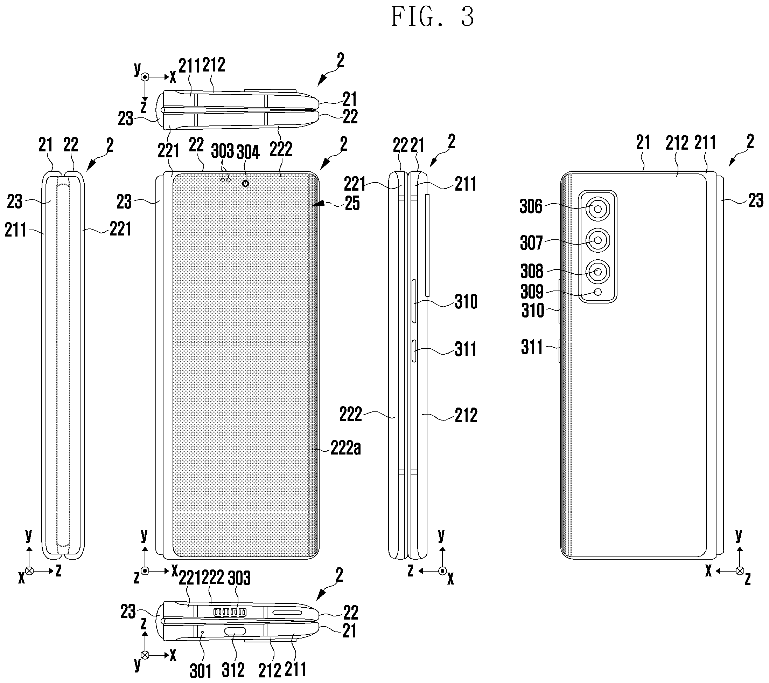

FIG. 2 shows views of a foldable electronic device 2 in an unfolded state (or an unfolding state or a flat state) according to an embodiment of the disclosure. FIG. 3 shows views of a foldable electronic device 2 in a folded state (or a folding state) according to an embodiment of the disclosure.

Referring to FIGS. 2 and 3, a foldable electronic device 2 includes a foldable housing 20 and a first display module (e.g., a flexible display module or a foldable display module) 24. The foldable electronic device 2 may further include a second display module 25. In various embodiments, the foldable electronic device 2 may be the electronic device 101 in FIG. 1.

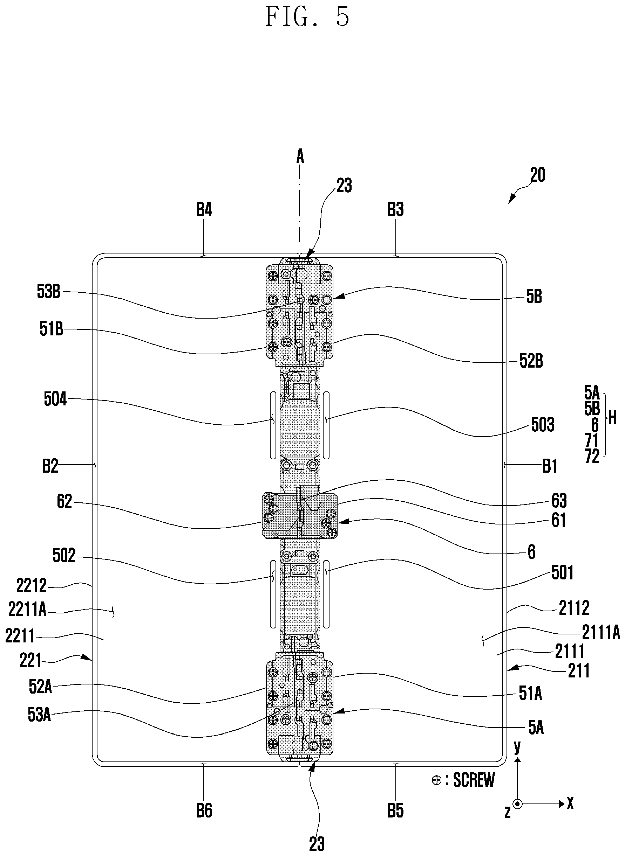

The foldable housing 20 includes a first housing (or a first housing part or a first housing structure) 21, a second housing (or a second housing part or a second housing structure) 22 and a hinge part. The foldable housing 20 may further include a hinge housing 23. The first housing 21 and the second housing 22 are connected through the hinge part and may mutually rotate around the hinge part. The hinge part may include one or more hinge modules (or hinge assemblies) (e.g., the first hinge module 5A or the second hinge module 5B in FIG. 5).

Among the first display module 24, a display area 24A of the first display module 24 may be an active area capable of displaying an image, and includes a first display area (or a first active area or a first screen area) ①, a second display area (or a second active area or a second screen area) ②, and a third display area (or a third active area or a third screen area) ③ for connecting the first display area ① and the second display area ②. The first display area ① is positioned to correspond to the first housing 21. The second display area ② is positioned to correspond to the second housing 22. The third display area ③ is positioned to correspond to the hinge part. The first display area ① is disposed in the first housing 21. The shape of the first display area ① may be maintained by the support of the first housing 21. The second display area ② is disposed in the second housing 22.The shape of the second display area ② may be maintained by the support of the second housing 22. For example, the first display area ① and the second display area ② may be provided substantially flat. An unfolded state (see FIG. 2) of the foldable electronic device 2 may be a state in which the third display area ③ is disposed to be substantially flat. In an unfolded state of the foldable electronic device 2, the first display area ① and the second display area ② may form an angle of about 180 degrees, and the display area 24A including the first display area ①, the second display area ②, and the third display area ③ may be provided (or disposed) in a substantially flat-surface shape. In an unfolded state of the foldable electronic device 2, due to the relative position between the first display area ① disposed in the first housing 21 and the second display area ② disposed in the second housing 22, the third display area ③ for connecting the first display area ① and the second display area ② may be disposed flat. In an unfolded state of the foldable electronic device 2, the third display area ③ may be pulled from opposite sides thereof by the first display area ① and the second display area ②, and the pulling force may be provided so as to reduce damage to the third display area ③ while allowing the third display area ③ to be disposed flat. In an unfolded state of the foldable electronic device 2, the third display area ③ may be pulled by the first display area ① and the second display area ②, and thus may be provided with an extended width which allows the third display area to be disposed flat while reducing the stress thereof. In an unfolded state of the foldable electronic device 2, the hinge part may support the third display area ③. In an unfolded state of the foldable electronic device 2, in case that an external force (e.g., an external pressure such as touch Input using a use's finger or touch input using an electronic pen) is applied to the third display area ③, the hinge part may reduce a sagging phenomenon of the third display area ③, and thus may contribute to that the third display area ③ is maintained flat. In an unfolded state of the foldable electronic device 2, in case that external impact is applied thereto due to a reason such as falling, the hinge part may be configured to reduce the influence of external impact on the third display area ③. In an unfolded state of the foldable electronic device 2, the hinge part may support the third display area ③ so that the third display area ③ is disposed flat without sagging, and thus may reduce the crease phenomenon thereof. The coordinate axes illustrated herein are illustrated with reference to the first housing 21, and for example, the +z-axis direction may be interpreted as a direction in which a flat surface provided by the flat first display area ① is oriented.

According to an embodiment, the foldable electronic device 2 may be provided in an in-folding type in which the display area 24A of the first display module 24 is folded inward. FIG. 3 shows a fully folded state of the foldable electronic device 2, in which the first housing 21 and the second housing 22 are arranged no longer close to each other. In the fully folded state of the foldable electronic device 2, the first display area ① and the second display area ② may be positioned to face each other, and the third display area ③ may be disposed in a bent (bended) shape. In the fully folded state of the foldable electronic device 2, the angle between the first housing 21 and the second housing 22 (or the angle between the first display area ① and the second display area ②) may be about 0 degrees - about 10 degrees or be about 0 degrees - about 5 degrees, and the display area 24A may be substantially invisible. Although not illustrated herein, an intermediate state of the foldable electronic device 2 may be a state between an unfolded state and a fully folded state. In the case of an intermediate state where the angle between the first housing 21 and the second housing 22 is equal to or more than a predetermined angle, a use environment in which there is no practical difficulty in using the display area 24A may be provided. Hereinafter, "a folded state of the foldable electronic device 2" disclosed in the disclosure may mean a fully folded state compared to an intermediate state which is a less folded state.

According to an embodiment, when referring to an unfolded state (see FIG. 2) of the foldable electronic device 2, the display area 24A of the first display module 24 may be provided in a symmetrical shape with reference to a central line A of the foldable electronic device 2. When referring to an unfolded state of the foldable electronic device 2, the central line A may correspond to the middle of the width in which the third display area ③ extends from a first boundary between the first display area ① and the third display area ③ to a second boundary between the second display area ② and the third display area ③. The third display area ③ disposed in a bent shape in a folded state (see FIG. 3) of the foldable electronic device 2 may have a substantially symmetrical shape with reference to the central line A of the foldable electronic device 2. When referring to an unfolded state of the foldable electronic device 2, the display area 24A may have a substantially rectangular shape. The display area 24A may include a first edge E1, a second edge E2, a third edge E3, and a fourth edge E4. The first edge E1 and the second edge E2 may be substantially parallel to the central line A. The third edge E3 may connect one end of the first edge E1 and one end of the second edge E2, and the fourth edge E4 may connect the other end of the first edge E1 and the other end of the second edge E2. The first display area ① may include the first edge E1, a part of the third edge E3, and a part of the fourth edge E4. The second display area ② may include the second edge E2, a part of the third edge E3, and a part of the fourth edge E4. The third display area ③ may include a part of the third edge E3 and a part of the fourth edge E4. In a folded state of the foldable electronic device 2, the first edge E1 and the second edge E2 may be aligned to overlap each other. In a folded state of the foldable electronic device 2, a part of the third edge E3, which is included in the first display area ①, and a part of the third edge E3, which is included in the second display area ②, may be aligned to overlap each other. In a folded state of the foldable electronic device 2, a part of the fourth edge E4, which is included in the first display area ①, and a part of the fourth edge E4, which is included in the second display area ②, may be aligned to overlap each other.

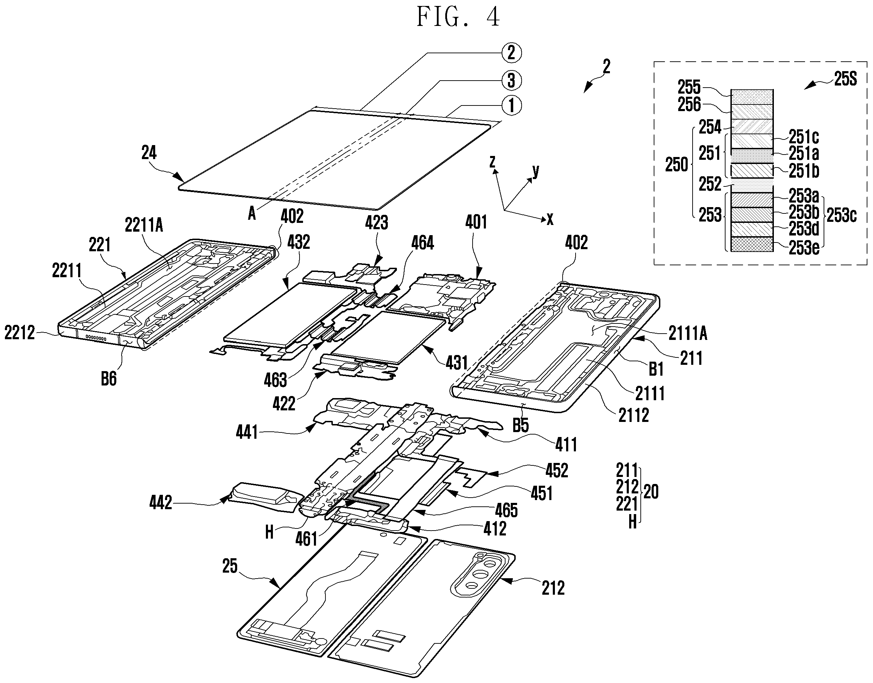

According to an embodiment, the first housing 21 may include a first frame (or a first frame structure or a first framework) 211. In a further embodiment, the first housing 21 may include a first cover 212 disposed on the first frame 211. The first frame 211 may include a first side (or a first side part, a first side member, a first side structure, or a first side bezel structure) (e.g., the first side 2112 in FIG. 4). The first side may be disposed along the edge of the first display area ① of the first display module 24. The first side may provide a first side surface of the foldable electronic device 2, which corresponds to the first display area ① of the foldable electronic device 2. The first frame 211 may include a first support part (e.g., the first support part 2111 in FIG. 4) which extends from the first side or is connected to the first side. The first display area ① may be disposed in the first support part, and the first support part may support the first display area ①. The first display area ① and the first cover 212 may be positioned at sides opposite to each other while having the first support part of the first frame 211, which is interposed therebetween. The first side of the first frame 211 may be disposed to surround at least a part of the space between the first display area ① and the first cover 212. The first display area ① may provide one surface among the outer surfaces of the foldable electronic device 2, and the first cover 212 may provide the other surface among the outer surfaces of the foldable electronic device 2, which is oriented in a direction substantially opposite to the first display area ①. Various electrical elements (or electronic components) such as a printed circuit board or a battery may be arranged in the first support part, between the first support part of the first frame 211 and the first cover 212.

According to an embodiment, the second housing 22 may include a second frame (or a second frame structure or a second framework) 221. In a further embodiment, the second housing 22 may include a second cover 222 disposed on the second frame 221. The second frame 221 may include a second side (or a second side part, a second side member, a second side structure, or a second side bezel structure) (e.g., the second side 2212 in FIG. 4). The second side may be disposed along the edge of the second display area ② of the first display module 24. The second side may provide a second side surface of the foldable electronic device 2, which corresponds to the second display area ② of the foldable electronic device 2. In a folded state (see FIG. 3) of the foldable electronic device 2, the first side of the first frame 211 and the second side of the second frame 221 may be aligned to overlap each other. The second frame 221 may include a second support part (e.g., the second support part 2211 in FIG. 4) which extends from the second side or is connected to the second side. The second display area ② may be disposed in the second support part, and the second support part may support the second display area ②. The second display area ② and the second cover 222 may be positioned at sides opposite to each other while having the second support part of the second frame 221, which is interposed therebetween. The second side of the second frame 221 may be disposed to surround at least a part of the space between the second display area ② and the second cover 222. The second display area ② may provide one surface among the outer surfaces of the foldable electronic device 2, and the second cover 222 may provide the other surface among the outer surfaces of the foldable electronic device 2, which is oriented in a direction substantially opposite to the second display area ②. Various electrical elements (or electronic components) such as a printed circuit board or a battery may be arranged in the second support part, between the second support part of the second frame 221 and the second cover 222.

According to an embodiment, the hinge housing (or a hinge cover) 23 may be coupled to a first hinge module 5A, a second hinge module 5B, and/or a third hinge module 6. In case that the foldable electronic device 2 is switched from an unfolded state (see FIG. 2) to a folded state (see FIG. 3), due to a change in the relative position between the first housing 21 and the second housing 22 connected to each other through a hinge part H, and a state change of the hinge part H coupled to the hinge housing 23, the gap between the first housing 21 and the second housing 22 is opened at the side opposite to the third display area ③, and thus the hinge housing 23 may be exposed to the outside through the open gap. In a folded state of the foldable electronic device 2, the hinge housing 23 may be a part of the exterior, which covers the inside of the foldable electronic device 2 exposed through the open gap between the first housing 21 and the second housing 22. The hinge housing 23 may be more exposed in the folded state in FIG. 3 than in an intermediate state. In case that the foldable electronic device 2 is switched from a folded state to an unfolded state, due to a change in the relative position between the first housing 21 and the second housing 22 connected to each other through a hinge part H, and a state change of the hinge part H coupled to the hinge housing 23, the gap between the first housing 21 and the second housing 22 is closed at the side opposite to the third display area ③, and the hinge housing 23 may be positioned in an inner space generated by the combination of the first housing 21 and the second housing 22 and thus may not be exposed to the outside.

According to an embodiment, the second display module 25 may be positioned between the second frame 221 and the second cover 222. The second cover 222 may be substantially transparent, and the second display module 25 may be visible through the second cover 222. The foldable electronic device 2 may be configured to display an image through the second display module 25 instead of the first display module 24 in a folded state.

According to various embodiments, the second display module 25 may be provided in a form including a second cover 222. In this case, the second cover 222 may be excluded from the foldable housing 20.

According to an embodiment, the first cover 212 may include a first curved-surface area 212a which is bent toward the first display area ① to correspond to the first edge E1 of the display area 24A and then extends seamlessly. The second cover 222 may include a second curved-surface area 222a which is bent toward the second display area ② to correspond to the second edge E2 of the display area 24A and then extends seamlessly. In an unfolded state (see FIG. 2) or a folded state (see FIG. 3) of the foldable electronic device 2, the first curved-surface area 212a and the second curved-surface area 222a may be provided symmetrically to each other at opposite sides, and thus may contribute to a beautiful outer appearance thereof. In an embodiment, the second display module 25 may include a flexible display capable of being disposed to be bent along the second curved-surface area 222a. In various embodiments, the first cover 212 may be provided substantially flat without the first curved-surface area 212a. In various embodiments, the second cover 222 may be provided substantially flat without the second curved-surface area 222a. In this case, the second display module 25 may include a rigid display.

According to an embodiment, the foldable electronic device 2 may include at least one of one or more audio modules (e.g., the audio module 170 in FIG. 1), one or more sensor modules (e.g., the sensor module 176 in FIG. 1), one or more camera modules (e.g., the camera module 180 in FIG. 1), one or more light-emitting modules, one or more input modules (e.g., the input module 150 in FIG. 1), and/or one or more connection terminal modules (e.g., the interface 177 or the connection terminal 178 in FIG. 1). In various embodiments, at least one of the elements may be omitted from the foldable electronic device 2, and other elements may be additionally included therein. The position or the number of the elements included in the foldable electronic device 2 is not limited to the illustrated example, and may be various.

For example, any one of the one or more audio modules may include a microphone positioned inside the foldable electronic device 2 to correspond to a microphone hole 301 provided through the exterior of the foldable electronic device 2. In the illustrated example, the microphone hole 301 may be provided through the first side of the first frame 211, and the microphone may be positioned in the inner space of the first housing 21. The position or the number of microphones and microphone holes is not limited to the illustrated example, and may be various. In various embodiments, the foldable electronic device 2 may include multiple microphones used to detect the direction of sound.

For example, any one of the one or more audio modules may include a first speaker for multimedia playback (or recording playback) positioned inside the foldable electronic device 2 to correspond to a first speaker hole 302 provided through the exterior of the foldable electronic device 2. In the illustrated example, the first speaker hole 302 may be provided through the second side of the second frame 221, and the first speaker may be positioned in the inner space of the second housing 22. For example, any one of the one or more audio modules may include a second speaker (e.g., a receiver for phone calling) positioned inside the foldable electronic device 2 to correspond to a second speaker hole (e.g., a receiver hole) 303 provided through the exterior of the foldable electronic device 2. In the illustrated example, the second speaker hole 303 may be provided through the second frame 221 to be adjacent to the second cover 222, and the second speaker may be positioned in the inner space of the second housing 22. The position or the number of speakers and speaker holes is not limited to the illustrated example, and may be various. In various embodiments, the microphone hole and the speaker hole may be implemented as a single hole. In various embodiments, a piezo speaker, in which a speaker hole is omitted, may be provided.

For example, the one or more sensor modules may generate electrical signals or data values corresponding to the internal operation state of the foldable electronic device 2 or the external environmental state. In an embodiment, any one of the one or more sensor modules may include an optical sensor 304 positioned in the inner space of the second housing 22 to correspond to the second cover 212. The optical sensor 304 may be positioned to be aligned with an opening provided through the second display module 25 or may be at least partially inserted into the opening. External light may reach the optical sensor through the second cover 222 and the opening provided through the second display module 25. For example, the optical sensor 304 may include a proximity sensor or an illuminance sensor. The number or the position of optical sensors is not limited to the illustrated example, and may be various.

According to various embodiments, in a view from above the second cover 222, the optical sensor 304 may be positioned in the inner space of the second housing 22 to at least partially overlap the display area of the second display module 25. In this case, a sensing function of the optical sensor 304 may be performed while the optical sensor 304 or the position of the optical sensor 304 is not visually distinguished (or exposed) or is invisible. In an embodiment, the optical sensor 304 may be positioned on the rear surface of the second display module 25 or below or beneath the second display module 25, and the optical sensor 304 or the position of the optical sensor 304 may not be visually distinguished (or exposed). In various embodiments, the optical sensor 304 may be positioned to be aligned with a recess provided on the rear surface of the second display module 25 or may be at least partially inserted into the recess. A partial area of the second display module 25, which is at least partially overlapped with the optical sensor 304, may include a different pixel structure and/or wire structure compared to other areas. For example, a partial area of the second display module 25, which is at least partially overlapped with the optical sensor 304, may have a different pixel density compared to other areas. A pixel structure and/or a wire structure formed in a partial area, which is at least partially overlapped with the optical sensor 304, of the second display module 25 may reduce light loss between the outside and the optical sensor 304. For another example, multiple pixels may not be arranged in a partial area of the second display module 25, which is at least partially overlapped with the optical sensor 304.

According to various embodiments, the disclosure is not limited to the optical sensor 304 such as a proximity sensor or an illuminance sensor, and various other sensors may be positioned to correspond to the opening provided through the second display module 25 or may be positioned on the rear surface of the second display module 25 or below the second display module 25. For example, an optical type, a capacitive type, or an ultrasonic type biometric sensor (e.g., fingerprint sensor) may be positioned to correspond to the opening provided through the second display module 25, or be positioned on the rear surface of the second display module 25 or below the second display module 25.

According to various embodiments, various sensors may be positioned to correspond to openings provided through the first display module 24, or be positioned on the rear surface of the first display module 24 or below the first display module 24.

According to various embodiments, the foldable electronic device 2 may include various other sensors (e.g., a gesture sensor, a gyro sensor, a barometric pressure sensor, a magnetic sensor, an acceleration sensor, a grip sensor, a color sensor, an infrared (IR) sensor, a temperature sensor, or a humidity sensor) in addition thereto, and the positions thereof may be various.

According to an embodiment, the one or more camera modules each may include one lens or multiple lenses, an image sensor, and/or an image signal processor. For example, the one or more camera modules may include a first camera module 305, a second camera module 306, a third camera module 307, and/or a fourth camera module 308.

According to an embodiment, the first camera module 305 may be positioned in the inner space of the second housing 22 to correspond to the second cover 222. The first camera module 305 may be positioned to be aligned with an opening provided through the second display module 25, or may be at least partially inserted into the opening. External light may reach the first camera module 305 through the second cover 222 and the opening of the second display module 25. The opening of the second display module 25, which is aligned or overlapped with the first camera module 305, may be provided in a through-hole shape as the illustrated example. In various embodiments, the opening of the second display module 25, which is aligned or overlapped with the first camera module 305, may be provided in a notch shape.

According to various embodiments, in a view from above the second cover 222, the first camera module 305 may be positioned in the inner space of the second housing 22 to at least partially overlap the display area of the second display module 25. In this case, the photographing function of the first camera module 305 may be performed while the first camera module 305 or the position of the first camera module 305 is not visually distinguished (or exposed) or is invisible. In an embodiment, the first camera module 305 may be positioned on the rear surface of the second display module 25 or below or beneath the second display module 25, and the first camera module 305 or the position of the first camera module 305 may not be visually distinguished (or exposed) or may be invisible. In various embodiments, the first camera module 305 may be positioned to be aligned with a recess provided on the rear surface of the second display module 25 or may be at least partially inserted into the recess. For example, the first camera module 305 may include a hidden display rear camera (e.g., an under display camera (UDC)). A partial area of the second display module 25, which is at least partially overlapped with the first camera module 305, may include a different pixel structure and/or wire structure compared to other areas. For example, a partial area of the second display module 25, which is at least partially overlapped with the first camera module 305, may have a different pixel density compared to other areas. A pixel structure and/or a wire structure formed in a partial area, which is at least partially overlapped with the first camera module 305, of the second display module 25 may reduce light loss between the outside and the optical sensor. For another example, multiple pixels may not be arranged in a partial area of the second display module 25, which is at least partially overlapped with the first camera module 305.

According to an embodiment, the second camera module 306, the third camera module 307, or the fourth camera module 308 may be positioned in the inner space of the first housing 21 to correspond to the first cover 212. The first cover 212 may include a camera cover part (e.g., a camera decoration part) disposed to correspond to the second camera module 306, the third camera module 307, and the fourth camera module 308. The camera cover part may include a camera hole (or a light-transmitting area) provided to correspond to the second camera module 306, a camera hole (or a light-transmitting area) provided to correspond to the third camera module 307, and a camera hole (or a light-transmitting area) provided to correspond to the fourth camera module 308. The number or the position of camera modules provided to correspond to the first cover 212 is not limited to the illustrated example, and may be various. The second camera module 306, the third camera module 307, and the fourth camera module 308 may have different attributes (e.g., angles of view) or functions. The second camera module 306, the third camera module 307, and the fourth camera module 308 may provide different angles of view (or lenses having different angles of view), and the foldable electronic device 2 may selectively use a corresponding camera module, based on a user selection related to an angle of view. Any one of the second camera module 306, the third camera module 307, and the fourth camera module 308 may include a wide-angle camera module, a telephoto camera module, a color camera module, a monochrome camera module, or an infrared (IR) camera (e.g., a time of flight (TOF) camera or a structured light camera) module. In various embodiments, the IR camera module may also operate as at least a part of a sensor module.

According to an embodiment, any one of the one or more light-emitting modules may include a flash 309 positioned in the inner space of the first housing 21 to correspond to a flash hole (or a light-transmitting area) provided in the camera cover part of the first cover 212. The flash 309 may include a light source for the second camera module 306, the third camera module 307, and/or the fourth camera module 308. For example, the flash 309 may include a light-emitting diode (LED) or a xenon lamp.

According to various embodiments, any one of the one or more light-emitting modules (e.g., a LED, an IR LED, or a xenon lamp) may be configured to provide state information of the foldable electronic device 2 in the form of light. In various embodiments, the light-emitting module may provide a light source operating in association with an operation of the first camera module 305.

According to an embodiment, the one or more input modules may include a first key input device 310 or a second key input device 311. In the illustrated example, the first key input device 310 or the second key input device 311 may be positioned in an opening provided through the first side of the first frame 211. The position or the number of input modules is not limited to the illustrated example, and may be various. In various embodiments, the foldable electronic device 2 may not include some or all of the key input devices, and a key input device not included therein may be implemented as a soft key through the first display module 24 or the second display module 25. In some embodiments, each of the input modules or each of the key input devices may include at least one sensor module.

For example, any one of the one or more connection terminal modules (or connector modules or interface terminal modules) may include a connector (or an interface terminal) positioned inside the foldable electronic device 2 to correspond to a connector hole 312 formed through the exterior of the foldable electronic device 2. In the illustrated example, the connector hole 312 may be provided through the first side of the first frame 211. The position or the number of connection terminal modules is not limited to the illustrated example, and may be various. The foldable electronic device 2 may transmit and/or receive power and/or data to and/or from an external electronic device electrically connected to the connector. In an embodiment, the connector may include a USB connector or an HDMI connector. In various embodiments, any one of the one or more connection terminal modules may include an audio connector (e.g., a headphone connector or an earset connector) and a connector hole provided through the exterior of the foldable electronic device 2 to correspond to the audio connector. In various embodiments, any one of the one or more connection terminal modules may include a memory card connector positioned inside the foldable electronic device 2 and a connector hole formed through the exterior of the foldable electronic device 2 to correspond to the memory card connector.

According to various embodiments, the foldable electronic device 2 may include an attachable/detachable pen input device (e.g., an electronic pen, a digital pen, or a stylus pen) (not shown). For example, the pen input device may be implemented to be insertable into the inner space of the first housing 21 or the second housing 22. For another example, the pen input device may be attachable to or detachable from the hinge housing 23. The hinge housing 23 may include a recess, and the pen input device may be fitted into the recess.

The foldable electronic device 2 may further include various elements according to a provision form thereof. Such elements may be variously changed according to the convergence trend of the foldable electronic device 2, and thus may not be enumerated. However, elements equivalent to the mentioned elements may be additionally included in the foldable electronic device 2. In various embodiments, according to a provision form thereof, specific elements may also be excluded from the above-described elements, or may also be replaced with other elements.

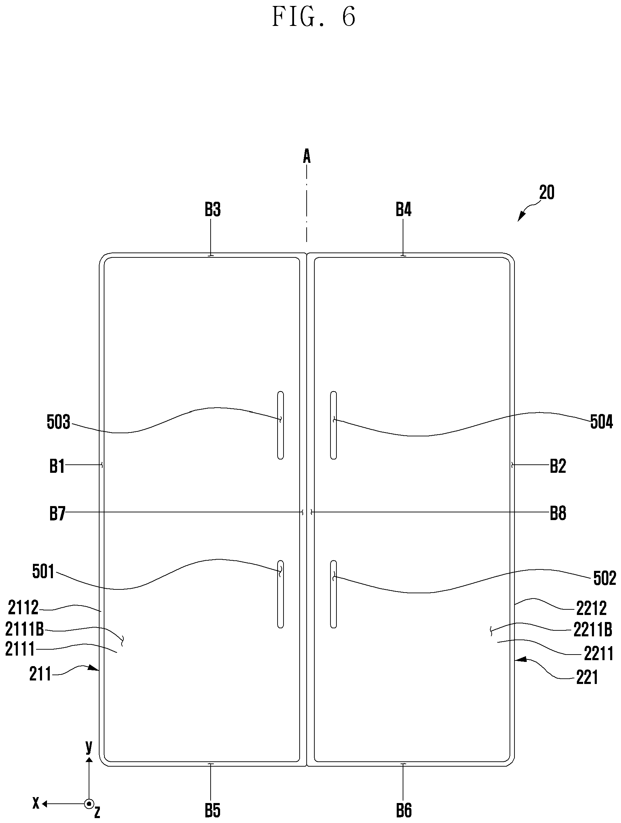

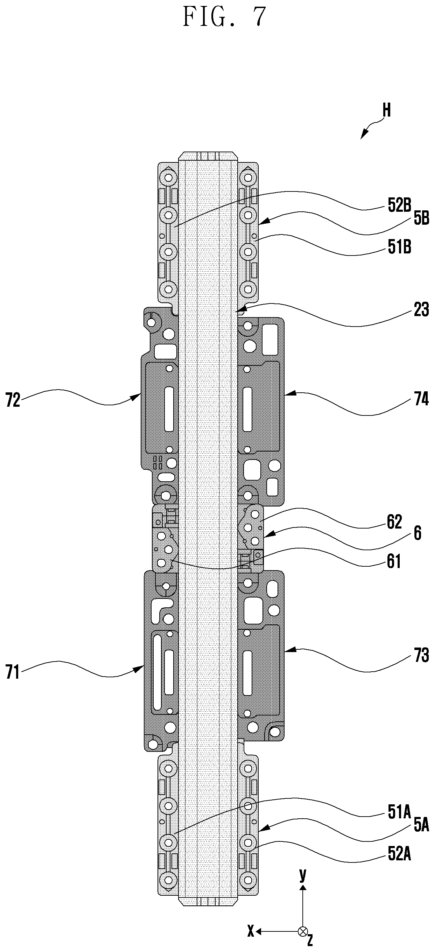

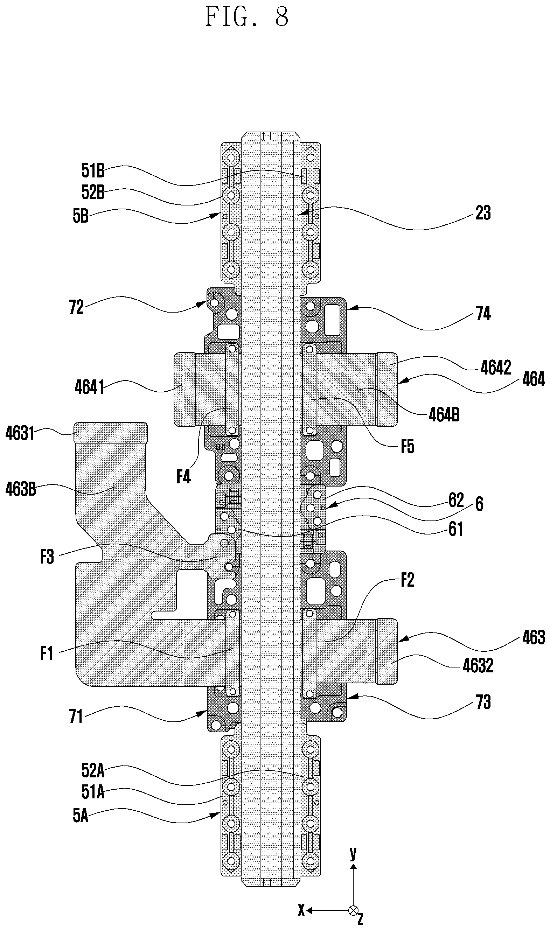

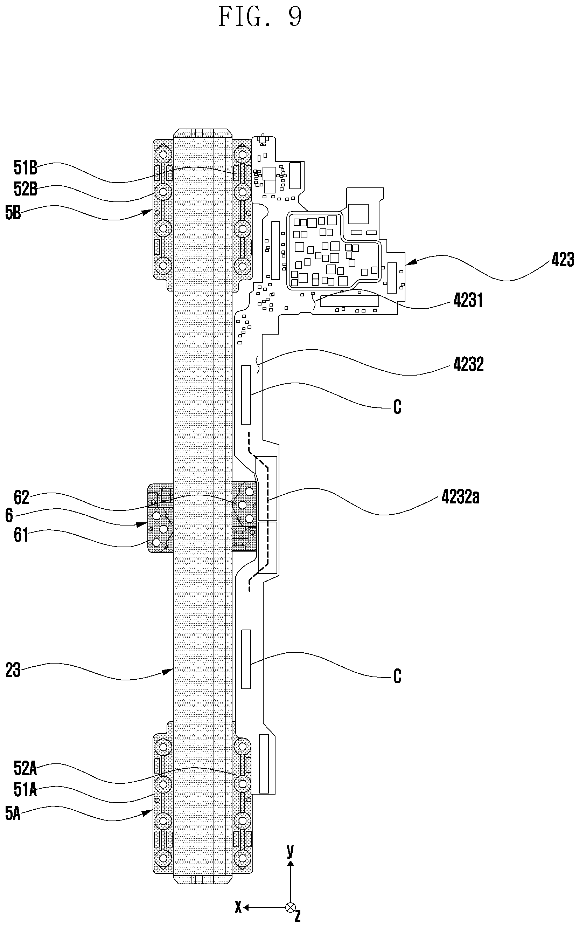

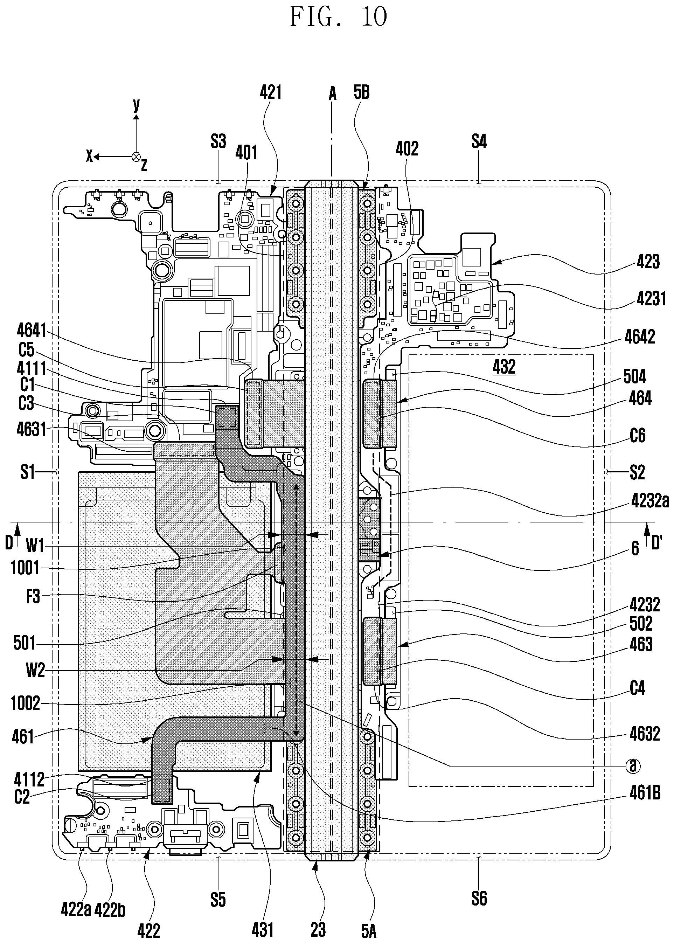

FIG. 4 is an exploded perspective view of a foldable electronic device 2 in an unfolded state according to an embodiment of the disclosure. FIGS. 5 and 6 are views showing a foldable housing 20 in an unfolded state according to an embodiment of the disclosure. FIG. 7 is a view showing a hinge part H according to an embodiment of the disclosure. FIG. 8 is a view showing a hinge part H, a third flexible printed circuit board 463, and a fourth flexible printed circuit board 464 according to an embodiment of the disclosure. FIG. 9 is a view showing a first hinge module 5A, a second hinge module 5B, a third hinge module 6, a hinge housing 23, and a third printed circuit board 423 according to an embodiment of the disclosure. FIG. 10 is a view showing a hinge part H, a first printed circuit board 421, a second printed circuit board 422, a third printed circuit board 423, a first battery 431, a first flexible printed circuit board 461, a third flexible printed circuit board 463, and a fourth flexible printed circuit board 464 according to an embodiment of the disclosure.

Referring to FIGS. 4, 5, 6, 7, 8, 9, and 10, the foldable electronic device 2 includes a foldable housing 20 and a first flexible printed circuit board 461. The foldable electronic device 2 may further include a first inner support body 411, a second inner support body 412, a first display module 24, a second display module 25, a first printed circuit board 421, a second printed circuit board 422, a third printed circuit board 423, a first battery 431, a second battery 432, a first speaker module 441, a second speaker module 442, a first antenna structure 451, a second antenna structure 452, a second flexible printed circuit board 462, a third flexible printed circuit board 463, and/or a fourth flexible printed circuit board 464.

According to an embodiment, the foldable housing 20 includes a hinge part H. The foldable housing 20 may further include a first frame 211, a first cover 212, and/or a second frame 221. The first housing 21 in FIG. 2 may include the first frame 211 and the second cover 212. The second housing 22 in FIG. 2 may include the second frame 221.

According to an embodiment, the first frame 211 may include a first support part 2111 and a first side 2112. The first frame 211 may be provided in an integrated form including the first support part 2111 and the first side 2112. The first support part 2111 may be an internal structure positioned inside the foldable electronic device 2 to correspond to the first housing 21 (see FIG. 2), and may be referred to as various other terms such as a "first bracket", a "first support body", a "first support member", or a "first support structure". The second frame 221 may include a second support part 2211 and a second side 2212. The second frame 221 may be provided in an integrated form including the second support part 2211 and the second side 2212. The second support part 2211 may be an internal structure positioned inside the foldable electronic device 2 to correspond to the second housing 22 (see FIG. 2), and may be referred to as various other terms such as a "second bracket", a "second support body", a "second support member", or a "second support structure". At least a part of the first frame 211 and/or at least a part of the second frame 221 may be formed of a metal material and/or a non-metal material (e.g., polymer). Electrical elements (or electronic components) or various members related to electrical elements may be arranged on the first frame 211 or in first support part 2111, and may be supported by the first frame 211 or the first support part 2111. The first support part 2111 may include a first support area 2111A toward the first display area ①, and a third support area 2111B oriented in a direction substantially opposite to the first support area 2111A (see FIG. 6). The first display area ① of the first display module 24 may be disposed in the first support area 2111A of the first support part 2111. Various elements such as the first printed circuit board 421, the second printed circuit board 422, or the first battery 431 may be disposed or coupled to the third support area 2111B. The second support part 2211 may include a second support area 2211A toward the second display area ②, and a fourth support area 2211B oriented in a direction substantially opposite to the second support area 2211A (see FIG. 6). The second display area ② of the first display module 24 may be disposed in the second support area 2211A of the second frame 221. Various elements such as the third printed circuit board 423 or the second battery 432 may be arranged or coupled to the fourth support area 2211B.

According to an embodiment, through various adhesive materials (or bonding materials) such as a thermally reactive adhesive material (or a thermally reactive bonding material), a photoreactive adhesive material (or a photoreactive bonding material), a general adhesive (or a general bonding material), and/or a double-sided tape, the first display area ① of the first display module 24) may be disposed in the first support part 2111 of the first frame 211, and the second display area ② of the first display module 24 may be disposed in the second support part 2211 of the second frame 221.

According to an embodiment, the hinge part H (see FIGS. 5 and 6) may include a first hinge module 5A, a second hinge module 5B and a third hinge module 6. In a further embodiment, the hinge part H may include a hinge housing 23, a first plate 71, a second plate 72, a third plate 73, and/or a fourth plate 74.

According to an embodiment, the first hinge module 5A, the second hinge module 5B, and the third hinge module 6 may connect the first frame 211 and the second frame 221. The first frame 211 and the second frame 221 may be rotatably connected to each other through the first hinge module 5A, the second hinge module 5B, and the third hinge module 6. The first hinge module 5A, the second hinge module 5B, and the third hinge module 6 may be arranged along the central line A of the foldable electronic device 2, and the third hinge module 6 may be positioned between the first hinge module 5A and the second hinge module 5B. In an embodiment, the third hinge module 6 may be positioned to correspond to the center (e.g., a point on the central line A, which is substantially the same distance from the first hinge module 5A and second hinge module 5B) between the first hinge module 5A and the second hinge module 5B.

According to an embodiment, the first housing 21, for example in particular the first frame 211 of the first housing 21, includes a first lateral part 401 (a side portion) corresponding to the hinge part H. The first lateral part 401 may include a part of the first support part 2111 included in the first frame 211. The second housing 22, for example in particular the second frame 221 of the second housing 22, includes a second lateral part 402 corresponding to the hinge part H. The second lateral part 402 may include a part of the second support part 2211 included in the second frame 221. The first hinge module 5A, the second hinge module 5B, and the third hinge module 6 may be coupled to the first lateral part 401 and the second lateral part 402.

According to an embodiment, the first hinge module 5A may include a first bracket 51A, a second bracket 52A, and/or a bracket connection part 53A. The first bracket 51A may be connected to the first lateral part 401 (of the first frame 211). The first bracket 51A may be disposed or coupled to the first support area 2111A of the first frame 211 through screw fastening. The second bracket 52A may be connected to the second lateral part 402 (of the second frame 221). The second bracket 52A may be disposed or coupled to the second support area 2211A of the second frame 221 through screw fastening. The bracket connection part 53A may connect the first bracket 51A and the second bracket 52A. The first bracket 51A and the second bracket 52A may be rotatable with respect to the bracket connection part 53A.

According to an embodiment, the bracket connection part 53A of the first hinge module 5A may be configured such that the first frame 211, to which the first bracket 51A is fixed, and the second frame 221, to which the second bracket 52A is fixed, are rotatable in directions opposite to each other at the same angle. The bracket connection part 53A may be configured such that the first frame 211, to which the first bracket 51A is fixed, and the second frame 221, to which the second bracket 52A is fixed, are rotated at at least one designated angle and then maintained. For example, the bracket connection part 53A may have a free-stop function. The bracket connection part 53A may be configured such that the first frame 211, to which the first bracket 51A is fixed, and the second frame 221, to which the second bracket 52A is fixed, provide a force enabling mutual rotation therebetween. For example, the bracket connection part 53A may be configured in a combination of at least one shaft, at least one cam gear, and/or at least one compression spring for providing elasticity.

The second hinge module 5B may be provided substantially the same as the first hinge module 5A, and for example, may include a first bracket 51B, a second bracket 52B, and/or a bracket connection part 53B. In an embodiment, the second hinge module 5B may be disposed in the foldable electronic device 2 in a direction opposite to the first hinge module 5A. The first bracket 51B of the second hinge module 5B may be connected to the second lateral part 402 of the second frame 221. The first bracket 51B of the second hinge module 5B may be disposed or coupled to the second support area 2211A of the second frame 221 through screw fastening. The second bracket 52B of the second hinge module 5B may be connected to the first lateral part 401 of the first frame 211. The second bracket 52B of the second hinge module 5B may be disposed or coupled to the first support area 2111A of the first frame 211 through screw fastening.

According to an embodiment, the third hinge module 6 may include a rotational motion guide or a guide rail assembly. For example, the third hinge module may include a first slider 61, a second slider 62, and a guide rail 63. The guide rail 63 may be disposed or coupled to the hinge housing 23. The hinge housing 23 may include a recess provided on one surface exposed to the outside in a folded state (see FIG. 3) of the foldable electronic device 2 and on the other surface opposite thereto, and the guide rail 63 may be disposed in the recess of the hinge housing 23 through screw fastening. The first slider 61 may be disposed on the guide rail 63 to be slidable with respect to the guide rail 63, and may be coupled to the first support part 2111 of the first frame 211 by a screw. The second slider 62 may be disposed on the guide rail 63 to be slidable with respect to the guide rail 63, and may be coupled to the second support part 2211 of the second frame 221 by a screw. The guide rail 63 may include a first guide rail (e.g., a first rotational motion guide rail) having a sliding pair relationship with the first slider 61, and a second guide rail (e.g., a second rotational motion guide rail) having a sliding pair relationship with the second slider 62. The third hinge module 6 may reduce a phenomenon in which the gap between the first frame 211 and the second frame 221 is opened. The third hinge module 6 is not limited thereto, and may be provided in various other types.

According to an embodiment, the first hinge module 5A, the second hinge module 5B, and the third hinge module 6 may be coupled to the hinge housing 23 by screws. The hinge housing 23 may be connected to the first frame 211 and the second frame 221 through the first hinge module 5A, the second hinge module 5B, and the third hinge module 6. The hinge housing 23 may include a recess provided on one surface exposed to the outside in a folded state (see FIG. 3) of the foldable electronic device 2 and on the other surface opposite thereto, and the bracket connection part 53A of the first hinge module 5A, the bracket connection part 53B of the second hinge module 5B, and the third hinge module 6 may be arranged in the recess of the hinge housing 23 through screw fastening.

According to an embodiment, the first plate 71 and the second plate 72 may be positioned to correspond to the first frame 211. The first plate 71 and the second plate 72 may be coupled to the first support part 2111 of the first frame 211 through screw fastening. In an unfolded state (see FIG. 2) of the foldable electronic device 2, the first hinge module 5A, the second hinge module 5B, the third hinge module 6, the first plate 71, the and second plate 72 may support one side area of the third display area ③ of the first display module 24 with reference to the central line A of the foldable electronic device 2. The first plate 71 may support a part of the third display area ③ of the first display module 24, which corresponds between the first hinge module 5A and the third hinge module 6. The second plate 72 may support a part of the third display area ③ of the first display module 24, which corresponds between the second hinge module 5B and the third hinge module 6.

According to an embodiment, the third plate 73 and the fourth plate 74 may be positioned to correspond to the second frame 221. The third plate 73 and the fourth plate 74 may be coupled to the second support part 2211 of the second frame 221 through screw fastening. In an unfolded state (see FIG. 2) of the foldable electronic device 2, the first hinge module 5A, the second hinge module 5B, the third hinge module 6, the third plate 73, and the fourth plate 74 may support the other side area of the third display area ③ of the first display module 24 with reference to the central line A of the foldable electronic device 2. The third plate 73 may support a part of the third display area ③ of the first display module 24, which corresponds between the first hinge module 5A and the third hinge module 6. The fourth plate 74 may support a part of the third display area ③ of the first display module 24, which corresponds between the second hinge module 5B and the third hinge module 6. In an unfolded state of the foldable electronic device 2, even though an external force (e.g., an external pressure such as touch input using a user's finger or touch input using an electronic pen) is applied to the third display area ③, the third display area ③ may be maintained flat due to the support of the first hinge module 5A, the second hinge module 5B, the third hinge module 6, the first plate 71, and the second plate 72. In an unfolded state of the foldable electronic device 2, the first hinge module 5A, the second hinge module 5B, the third hinge module 6, the first plate 71, and the second plate 72 may reduce or prevent the sagging phenomenon or the crease phenomenon of the third display area ③.

According to an embodiment, a first surface (not shown) of the first plate 71 may include a flat surface capable of supporting the third display area ③ of the first display module 24 in an unfolded state of the foldable electronic device 2. A second surface (not shown) of the second plate 72 may include a flat surface capable of supporting the third display area ③ in an unfolded state of the foldable electronic device 2. A third surface (not shown) of the third plate 73 may include a flat surface capable of supporting the third display area ③ in an unfolded state of the foldable electronic device 2. A fourth surface (not shown) of the fourth plate 74 may include a flat surface capable of supporting the third display area ③ in an unfolded state of the foldable electronic device 2. The first surface of the first plate 71 and the third surface of the third plate 73 may face each other in a folded state of the foldable electronic device 2, and may substantially form an angle of about 180 degrees in an unfolded state of the foldable electronic device 2. The second surface of the second plate 72 and the fourth surface of the fourth plate 74 may face each other in a folded state of the foldable electronic device 2, and may substantially form an angle of about 180 degrees in an unfolded state of the foldable electronic device 2. In an unfolded state of the foldable electronic device 2, the first surface of the first plate 71, the second surface of the second plate 72, the third surface of the third plate 73, and the fourth surface of the fourth plate 74 may be arranged without a substantial height difference with a surface of the first hinge module 5A, which supports the third display area ③ of the first display module 24, a surface of the second hinge module 5B, which supports the third display area ③, and a surface of the third hinge module 6, which supports the third display area ③.

According to various embodiments, in case that the foldable electronic device 2 is switched from an unfolded state (see FIG. 2) to a folded state (see FIG. 3), the hinge part H may be configured to provide a space which allows the third display area ③ of the first display module 24 to be disposed in a bent shape capable of reducing the bending stress thereof. In case that the foldable electronic device 2 is switched from an unfolded state to a folded state, the hinge part H may be configured to provide a space which allows the third display area ③ to be disposed in a bent shape capable of reducing the buckling phenomenon thereof. In an embodiment, in case that the foldable electronic device 2 is switched from an unfolded state to a folded state, the third display area ③ may be disposed in a water drop shape or a dumbbell shape capable of reducing damage or permanent deformation.

According to an embodiment (see FIG. 5), the first side 2112 of the first frame 211 may include a first bezel B1, a third bezel B3, a fifth bezel B5, and/or a seventh bezel B7. The second side 2212 of the second frame 221 may include a second bezel B2, a fourth bezel B4, a sixth bezel B6, and/or an eighth bezel B8.

According to an embodiment, the first bezel B1 may extend parallel to the direction (e.g., the y-axis direction) of the central line A of the foldable electronic device 2. The first bezel B1 may be positioned to correspond to the first edge E1 (see FIG. 2) of the display area 24A. The third bezel B3 may extend from one end of the first bezel B1 in a direction perpendicular to the direction of the central line A of the electronic device 2. The fifth bezel B5 may extend from the other end of the first bezel B1 in a direction perpendicular to the direction of the central line A of the electronic device 2, and may be substantially parallel to the third bezel B3. The third bezel B3 may be positioned to correspond to a part of the third edge E3 (see FIG. 2) of the display area 24A, which is included in the first display area ①. The fifth bezel B5 may be positioned to correspond to a part of the fourth edge E4 (see FIG. 2) of the display area 24A, which is included in the first display area ①. The seventh bezel B7 may extend parallel to the direction of the central line A of the foldable electronic device 2. The seventh bezel B7 may be positioned to be spaced apart from the first bezel B1 in a direction perpendicular to the direction of the central line A of the foldable electronic device 2, and may connect the third bezel B3 and the fifth bezel B5. In a view from above the first cover 212, the first cover 212 may be disposed to be surrounded by the first bezel B1, the third bezel B3, the fifth bezel B5, and the seventh bezel B7.

According to an embodiment, the seventh bezel B7 may be a part of the first lateral part 401 (see FIG. 4) included in the first frame 211.

According to an embodiment, the second bezel B2 may extend parallel to the direction (e.g., the y-axis direction) of the central line A of the foldable electronic device 2. The second bezel B2 may be positioned to correspond to the second edge E2 (see FIG. 2) of the display area 24A. The fourth bezel B4 may extend from one end of the second bezel B2 in a direction perpendicular to the direction of the central line A of the electronic device 2. The sixth bezel B6 may extend from the other end of the second bezel B2 in a direction perpendicular to the direction of the central line A of the electronic device 2, and may be substantially parallel to the fourth bezel B4. The fourth bezel B4 may be positioned to correspond to a part of the third edge E3 (see FIG. 2) of the display area 24A, which is included in the second display area ②. The sixth bezel B6 may be positioned to correspond to a part of the fourth edge E4 (see FIG. 2) of the display area 24A, which is included in the second display area ②. The eighth bezel B8 may extend parallel to the direction of the central line A of the foldable electronic device 2. The eighth bezel B8 may be positioned to be spaced apart from the second bezel B2 in a direction perpendicular to the direction of the central line A of the foldable electronic device 2, and may connect the fourth bezel B4 and the sixth bezel B6. In a view from above the second display module 25, the second display module 25 may be disposed to be surrounded by the second bezel B2, the fourth bezel B4, the sixth bezel B6, and the eighth bezel B8.

According to an embodiment, the eighth bezel B8 may be a part of the second lateral part 402 (see FIG. 4) included in the second frame 221.

According to an embodiment, in a folded state (see FIG. 3) of the foldable electronic device 2, the first bezel B1 and the second bezel B2 may be aligned. In a folded state of the foldable electronic device 2, the third bezel B3 and the fourth bezel B4 may be aligned. In a folded state of the foldable electronic device 2, the fifth bezel B5 and the sixth bezel B6 may be aligned.

According to an embodiment, in an unfolded state of the foldable electronic device 2, the gap between the seventh bezel B7 of the first frame 211 and the eighth bezel B8 of the second frame 221 may be closed, and thus the hinge housing 23 may not be substantially exposed to the outside. In a folded state of the foldable electronic device 2, the gap between the seventh bezel B7 of the first frame 211 and the eighth bezel B8 of the second frame 221 may be opened, and thus the hinge housing 23 may be exposed to the outside.

According to an embodiment, in a view from above the first cover 212 (or in a view from above the first display area ① of the first display module 24), the first printed circuit board 421 may be positioned closer to the third bezel B3 than the fifth bezel B5. In connection with terms described in the disclosure, the wording "in a view from above the first display area ①" may be used instead of the wording "in a view from above the first cover 212". In a view from above the first cover 212, the second printed circuit board 422 may be positioned closer to the fifth bezel B5 than the third bezel B3. In a view from above the first cover 212, the first battery 431 may be positioned between the first printed circuit board 421 and the second printed circuit board 422.

According to an embodiment, in a view from above the second display module 25 (or in a view from above the second display area ② of the first display module 24), the third printed circuit board 423 may include a first substrate area 4231 and a second substrate area 4232 extending from the first substrate area 4231. In connection with terms described in the disclosure, the wording "in a view from above the second display area ②" may be used instead of the wording "in a view from above the second display module 25". In a view from above the second display module 25, the first substrate area 4231 may be positioned closer to the fourth bezel B4 than the sixth bezel B6. In a view from above the second display module 25, the second substrate area 4232 may be positioned between the second battery 432 and the eighth bezel B8 (see FIG. 6).

According to an embodiment, the first frame 211 may include a first connection area (not shown) connected to the first slider 61 of the third hinge module 6. The first connection area may be included in the first lateral part 401 in FIG. 4, and may be connected to the seventh bezel B7. For example, the first connection area may include a recess into which the first slider 61 is inserted. For example, the first connection area may include screw fastening parts corresponding to screw holes of the first slider 61. Each of the screw fastening parts may be a boss including a female thread corresponding to the male thread of a screw. According to an embodiment, the second frame 221 may include a second connection area (not shown) connected to the second slider 62 of the third hinge module 6. The second connection area may be included in the second lateral part 402 in FIG. 4, and may be connected to the eighth bezel B8. For example, the second connection area may include a recess into which the second slider 62 is inserted. For example, the second connection area may include screw fastening parts corresponding to screw holes of the second slider 62.

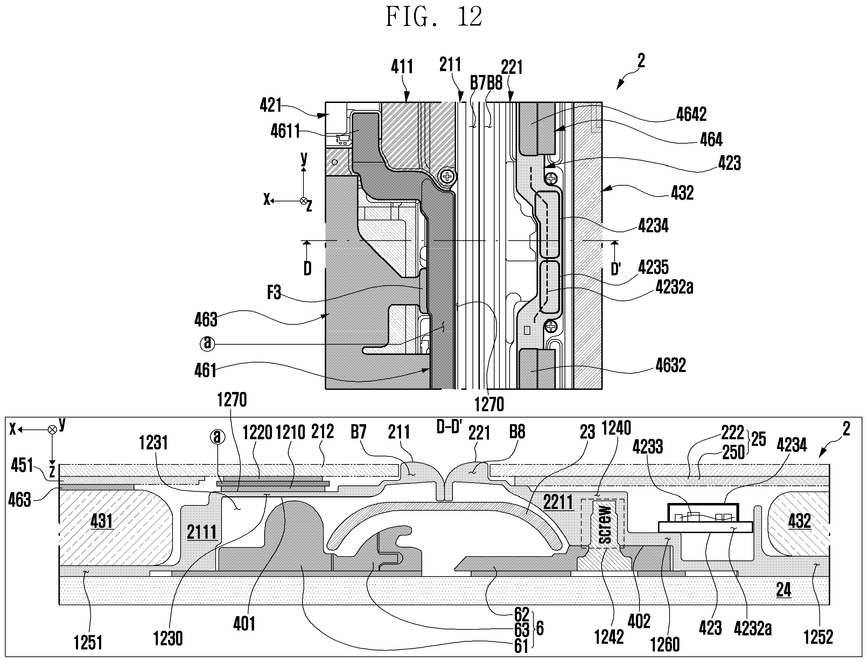

According to an embodiment, in a view from above of the second display module 25, a part 4232a (see FIGS. 9 and 10) of the second substrate area 4232 of the third printed circuit board 423 may be provided in a shape (e.g., an avoidance shape) which does not overlap the second connection area (e.g., the portion coupled to the second slider 62 of the third hinge module 6) (see the reference numeral "1240" in FIG. 12) of the second frame 221.

According to an embodiment, the first inner support body 411 may be positioned between the first support part 2111 of the first frame 211 and the first cover 212. The first inner support body 411 may be coupled to the first support part 2111. The first inner support body 411 may cover an element such as the first printed circuit board 421 disposed in the first support part 2111 of the first frame 211. At least a part of the first printed circuit board 421 may be positioned between the first support part 2111 and the second inner support body 412.

According to various embodiments, the first inner support body 411 may include a non-metal material, and a conductive pattern used as an antenna radiator may be disposed in the first inner support body 411. The conductive pattern used as an antenna radiator may be electrically connected to the first printed circuit board 421. In an embodiment, at least one flexible conductive part (not shown) may be disposed between the first inner support body 411 and the first printed circuit board 421, and the conductive pattern of the first inner support body 411 may be electrically connected to the first printed circuit board 421 through the flexible conductive part. For example, the flexible conductive part may be various such as a conductive clip (e.g., a conductive structure including an elastic structure), a pogo-pin, a spring, a conductive PORON, a conductive rubber, a conductive tape, or a conductive connector.

According to an embodiment, the second inner support body 412 may be positioned between the first support part 2111 of the first frame 211 and the first cover 212. The second inner support body 412 may be coupled to the first support part 2111. In a view from above the first cover 212 (e.g., when seen in the +z-axis direction), the first battery 431 may be positioned between the first inner support body 411 and the second inner support body 412. The second inner support body 412 may cover an element such as the third printed circuit board 423 disposed in the first support part 2111 of the first frame 211. At least a part of the third printed circuit board 423 may be positioned between the first support part 2111 and the second inner support body 412. The first frame 211 may be referred to as a "first front case", and the first inner support body 411 and/or the second inner support body 412 may be referred to as a "first rear case".

According to an embodiment, the second inner support body 412 may include a non-metal material, and a conductive pattern used as an antenna radiator may be disposed in the second inner support body 412. The conductive pattern used as an antenna radiator may be electrically connected to the second printed circuit board 422. In an embodiment, at least one flexible conductive part (not shown) may be disposed between the second inner support body 412 and the second printed circuit board 422, and the conductive pattern of the second inner support body 412 may be electrically connected to the second printed circuit board 422 through the flexible conductive part. For example, the flexible conductive part may be various such as a conductive clip (e.g., a conductive structure including an elastic structure), a pogo-pin, a spring, a conductive PORON, a conductive rubber, a conductive tape, or a conductive connector.

According to various embodiments, the foldable electronic device 2 may further include a third inner support body (not shown) positioned between a second support part 2211 of second frame 221 and the second display module 25. The third inner support body may be coupled to the second support part 2211. The third inner support body may support the second display module 25 (or the rear surface of the second display module 25).

According to an embodiment, when referring to the cross-sectional view 25S of the second display module 25, the second display module 25 may include a display 250, a transparent cover 255, and/or an optical transparent adhesive part (or an optical transparent bonding part) 256. For example, the display 250 may be coupled to the transparent cover 255 by using the optical transparent adhesive part 256 (e.g., optical clear adhesive (OCA), optical clear resin (OCR), or super view resin (SVR)). The transparent cover 255 (e.g., a window) may cover the display 250 to protect the display 250 from the outside. The transparent cover 255 may provide the rear surface of the foldable electronic device 2. In various embodiments, the transparent cover 255 may be the second cover 222 in FIG. 2. For example, the transparent cover 255 may include polymer or glass. In various embodiments, the transparent cover 255 may include multiple layers. For example, the transparent cover 255 may have a form in which various coating layers are arranged on a plastic plate or a glass plate. For example, the transparent cover 255 may have a form in which a coating layer or at least one protective layer including a polymer material (e.g., polyester (PET), polyimide (PI), or thermoplastic polyurethane (TPU)) is disposed on a plastic plate or a thin-film plate. In various embodiments, the transparent cover 255 and the optical transparent adhesive part 256 may be defined or interpreted as a part of the display 250. In various embodiments, the transparent cover 255 may be interpreted as a part of the foldable housing 20 rather than the second display module 25. For example, the display 250 may include a display panel 251, a base film 252, a lower panel 253, and/or an optical layer 254. The display panel 251 may be positioned between the optical layer 254 and the base film 252. The base film 252 may be positioned between the display panel 251 and the lower panel 253. The optical layer 254 may be positioned between the optical transparent adhesive part 256 and the display panel 251. An adhesive material (or an adhesive member) or a bonding material (or a bonding member) made of various polymers may be disposed between the display panel 251 and the base film 252, between the base film 252 and the lower panel 253, and/or between the display panel 251 and the optical layer 254. For example, the display panel 251 may include a light-emitting layer 251 a, a thin-film transistor (TFT) film (or a TFT substrate) 251 b, and/or an encapsulation (e.g., a thin-film encapsulation (TFE)) 251c. For example, the light-emitting layer 251a may include multiple pixels implemented by a light-emitting element such as an organic light-emitting diode (OLED) or a micro-LED. The light-emitting layer 251a may be disposed on the TFT film 251b through organic evaporation. The TFT film 251b may be positioned between the light-emitting layer 251a and the base film 252. The TFT film 251b may mean a film structure in which at least one TFT is disposed on a flexible substrate (e.g., a PI film) through a series of processes such as deposition, patterning, and/or etching. The at least one TFT may control a current for a light-emitting element of the light-emitting layer 251a so as to adjust ON or OFF of a pixel, or the brightness of a pixel. For example, the at least one TFT may be implemented with an amorphous silicon (a-Si) TFT, a liquid crystalline polymer (LCP) TFT, a low-temperature polycrystalline oxide (LTPO) TFT, or a low-temperature polycrystalline silicon (LTPS) TFT. In an embodiment, the display panel 251 may include a storage capacitor, and the storage capacitor may maintain a voltage signal to a pixel, may maintain voltage applied to a pixel within one frame, or may reduce a gate voltage change of a TFT, caused by a leakage current during light-emitting time. The storage capacitor may maintain voltage applied to a pixel at predetermined time interval by a routine (e.g., initialization or data write) for controlling the at least one TFT. In an embodiment, the display panel 251 may be implemented based on an OLED, and the encapsulation 251c may cover the light-emitting layer 251a. An organic material for emitting light in an OLED and an electrode may react very sensitively to oxygen and/or moisture, and thus may lose the light-emitting property thereof. In order to reduce or prevent same, the encapsulation 251c may seal the light-emitting layer 251a so that oxygen and/or moisture does not permeate into the OLED. The base film 252 may function to support and protect the display panel 251. In various embodiments, the base film 252 may be referred to as a "protective film", a "back film", or a "back plate". The lower panel 253 may include multiple layers for various functions. Various polymeric adhesive materials (or bonding materials) (not shown) may be arranged between the multiple layers included in the lower panel 253. In an embodiment, for example, the lower panel 253 may include a light-blocking layer 253a, a buffer layer 253b, and/or a lower layer 253c. The light-blocking layer 253a may be positioned between the base film 252 and the buffer layer 253b. The buffer layer 253b may be positioned between the light-blocking layer 253a and the lower layer 253c. The light-blocking layer 253a may block at least a part of light having been incident from the outside. For example, the light-blocking layer 253a may include an embossed layer. The embossed layer may be a black layer including a bumpy pattern. The buffer layer 253b may mitigate external impact applied to the display 250. For example, the buffer layer 253b may include a sponge layer or a cushion layer. The lower layer 253c may disperse, diffuse, or dissipate heat generated in the foldable electronic device 2 or the display 250. The lower layer 253c may absorb or shield electromagnetic waves. The lower layer 253c may mitigate external impact applied to the foldable electronic device 2 or the display 250. For example, the lower layer 253c may include a composite sheet 253d or a metal sheet 253e. In an embodiment, the composite sheet 253d may be a sheet formed by combining and processing layers or sheets having different properties. For example, the composite sheet 253d may include at least one of polyimide or graphite. The composite sheet 253d may be replaced with a single sheet including one material (e.g., polyimide or graphite). The composite sheet 253d may be positioned between the buffer layer 253b and the metal sheet 253e. For example, the metal sheet 253e may be a copper sheet. For example, the metal sheet 253e may include various other metal materials. The metal sheet 253e may reduce electromagnetic interference (EMI) on the second display module 25 or the display 250. In various embodiments, at least a part of the lower layer 253c may be a conductive member (e.g., a metal plate), may help to reinforce rigidity of the foldable electronic device 2, and may be used to shield ambient noise and dissipate heat emitted from a heat dissipation component (e.g., a display drive circuit) (e.g., a display drive integrated circuit (DDI)) therearound. For example, the conductive member may include at least one of copper (CU), aluminum (Al), stainless steel (SUS), or a CLAD (e.g., a lamination member in which SUS and Al are alternately arranged). The lower layer 253c may include various layers for various other functions. In various embodiments (not shown), at least one additional polymer layer (e.g., a layer including PI, PET, or TPU) may also be further disposed on the rear surface of the display panel 251 in addition to the base film 252. In various embodiments, at least one of multiple layers (e.g., the light-blocking layer 253a, the buffer layer 253b, the composite sheet 253d, and the metal sheet 253e) included in the lower panel 253 may be omitted. In various embodiments, the arrangement order of the multiple layers included in the lower panel 253 is not limited to the illustrated embodiment, and may be variously changed. For example, the optical layer 254 may include a polarizing layer (or a polarizer) or a phase retardation layer (or retarder). The polarizing layer and the phase retardation layer may improve outdoor visibility of a screen. For example, the optical layer 254 may selectively transmit light which is generated from a light source of the display panel 251 and vibrates in a predetermined direction. In various embodiments, one layer, in which the polarizing layer and the phase retardation layer are combined, may be provided, and such layer may be interpreted as a "circular polarization layer". The optical transparent adhesive part 256 may be positioned between the transparent cover 255 and the optical layer 254. In various embodiments, the polarizing layer (or the circular polarization layer) may be omitted, and in this case, a black pixel define layer (PDL) and/or a color filter may be provided to replace the polarizing layer. In an embodiment, the foldable electronic device 2 may include a touch detection circuit (e.g., a touch sensor) (not shown). The touch detection circuit may be implemented with a transparent layer (or film) based on various conductive materials such as indium tin oxide (ITO). In an embodiment, the touch detection circuit may be disposed between the transparent cover 255 and the optical layer 254 (e.g., an add-on type). In various embodiments, the touch detection circuit may be disposed between the optical layer 254 and the display panel 251 (e.g., an on-cell type). In various embodiments, the display panel 251 may include a touch detection circuit or a touch detection function (e.g., an in-cell type). In various embodiments, the display panel 251 may be based on an OLED, and may include the encapsulation 251c positioned between the light-emitting layer 251a and the optical layer 254. The encapsulation 251c may perform a function of a pixel protective layer for protecting multiple pixels of the light-emitting layer 251a. Multiple layers included in the display panel 251 or the lower panel 253, the lamination structure thereof, or the lamination order thereof may be various. The display 250, according to the type of provision or the convergence trend, may be implemented by omitting a part of elements or adding other elements.

According to various embodiments, the second display module 25 may be a flexible display module. In this case, the display 250 may be a flexible display. The transparent cover 255 may be implemented in the form of a thin film (e.g., a thin-film layer) having flexibility. For example, the transparent cover 255 may include a plastic film (e.g., a polyimide (PI) film) or thin-film glass (e.g., ultra-thin glass (UTG)). In various embodiments, the transparent cover 255 may include multiple layers. For example, the transparent cover 255 may have a form in which various coating layers are arranged on a plastic film or thin-film glass. For example, the transparent cover 255 may have a form in which a coating layer or at least one protective layer including a polymer material (e.g., polyester (PET), polyimide (PI), or thermoplastic polyurethane (TPU)) is disposed on a plastic film or thin-film glass. The base film 252 may include a flexible film formed of plastic or polymer such as polyimide or polyester (PET). In an embodiment, the display 250 may include a conductive pattern such as a metal mesh (e.g., an aluminum metal mesh), as a touch detection circuit disposed on the encapsulation 251c, between the encapsulation 251c and the optical layer 254. For example, in response to the bending of the display 250, the metal mesh may have durability greater than that of a transparent conductive layer implemented with an ITO. In various embodiments, the display 250 may further include a pressure sensor (not shown) capable of measuring the intensity (pressure) of a touch. In an embodiment, the first display module 24 may include at least a part of the elements included in the flexible display module described above.

According to various embodiments, the first display module 24 may include a support sheet (or a support plate or a support layer). The support sheet may be disposed on the rear surface of a flexible display (e.g., the display 250 implemented as a flexible display). The rear surface of the flexible display may be a surface positioned at a side opposite to a surface of a display panel including multiple pixels, from which light is emitted. The support sheet may be disposed on (e.g., attached to) the rear surface of a lower panel while covering at least a part of the lower panel (e.g., the lower panel 253) of the flexible display. The support sheet may be coupled to the lower panel by an adhesive material or a bonding material. For example, an adhesive material (or a bonding material) between the flexible display and the support sheet may include a thermally reactive adhesive material (or a thermally reactive bonding material), a photoreactive adhesive material (or a photoreactive bonding material), a general adhesive (or a general bonding material), or a double-sided tape. For another example, the adhesive material (or the bonding material) may include various polymers such as triazine thiol, dithiopyrimitine, or silane-based compounds, or an organic adhesive material (or an organic bonding material) such as sealant. The support sheet may contribute to durability (e.g., rigidity reinforcement) of the first display module 24. The support sheet may reduce the influence, caused by load or stress which may occur during folding of the foldable housing 20, on the first display module 24 (or a flexible display). The support sheet may reduce or prevent that the first display module 24 is damaged by a force transmitted when the foldable housing 20 is folded. In an embodiment, the support sheet may include a metal material. For example, the support sheet may include stainless steel. The support sheet may include various other metal materials. In various embodiments, the support sheet may include engineering plastic.

According to an embodiment, the support sheet included in the first display module 24 may include a lattice structure (not shown) which is at least partially overlapped with the third display area ③ (see FIG. 2) of the first display module 24. For example, the lattice structure may include multiple openings (or slits) provided through the support sheet. The lattice structure may mean a pattern structure in which multiple openings are regularly arranged. The multiple openings may be periodically formed, may have substantially the same shape, and may be repeatedly arranged at a predetermined interval. The lattice structure may reduce the deterioration of flexibility of the third display area ③. In various embodiments, the lattice structure including multiple openings may be referred to as other terms such as an "opening pattern", a "hole pattern", or a "lattice pattern". In various embodiments, the support sheet may include a recess pattern (not shown) including multiple recesses in place of the lattice structure. For example, the recess pattern may mean a pattern structure in which multiple recesses are regularly arranged, the multiple recesses being provided on a first surface of the support sheet, which faces the lower panel of the flexible display, or on a second surface positioned at the side opposite to the first surface of the support sheet and having a dented shape. In various embodiments, the lattice structure or the recess pattern may be expanded to a portion corresponding to the first display area ① (see FIG. 2) and/or the second display area ② (see FIG. 2) of the support sheet of the first display module 24. In various embodiments, the support sheet including a lattice structure or a recess pattern, or the conductive member corresponding thereto may be provided as multiple layers. In various embodiments, the support sheet may reduce electromagnetic interference (EMI) on the flexible display. In various embodiments, the support sheet may diffuse or spread heat emitted from a heat dissipation component (e.g., a display drive circuit such as a display drive integrated circuit (DDI) or a DDI chip). In various embodiments, the support sheet may be interpreted as a separate element from the first display module 24.

According to an embodiment, the first speaker module (or a first speaker assembly) 441 may be positioned between the second support part 2211 of the second frame 221 and the second display module 25. The first speaker module 441 may be disposed or coupled to the second support part 2211. For example, the first speaker module 441 may include a first speaker and a first speaker support body to which the first speaker is disposed or coupled. The first speaker support body may provide a sound movement path (or passage) between the first speaker and a first speaker hole provided through the second side 2212 of the second frame 221.

According to an embodiment, the second speaker module (or a second speaker assembly) 442 may be positioned between the second support part 2211 of the second frame 221 and the second display module 25. The second speaker module 442 may be disposed or coupled to the second support part 2211. For example, the second speaker module 442 may include a second speaker and a second speaker support body to which the second speaker is disposed or coupled. The second speaker support body may provide a sound movement path (or passage) between the second speaker and a second speaker hole provided through the second side 2212 of the second frame 221.

According to an embodiment, the first antenna structure 451 may be positioned between the first support part 2111 of the first frame 211 and the first cover 212. The first antenna structure 451 may be disposed on a surface of the first battery 431, which faces the first cover 212, or on the first cover 212. The position of the first antenna structure 451 is not limited thereto, and may be various. For example, the first antenna structure 451 may be implemented in a film shape such as an FPCB. The first antenna structure 451 may include at least one conductive pattern used as a loop type radiator. For example, at least one conductive pattern included in the first antenna structure 451 may include a planar-shaped spiral conductive pattern (e.g., a planar coil or a pattern coil). In an embodiment, at least one conductive pattern included in the first antenna structure 451 may be electrically connected to a wireless communication circuit (e.g., the wireless communication module 192 in FIG. 1) disposed on the first printed circuit board 421. For example, the at least one conductive pattern may be used for short-range wireless communication such as near field communication (NFC). For another example, the at least one conductive pattern may be used for magnetic secure transmission (MST) for transmitting and/or receiving a magnetic signal. In various embodiments, the at least one conductive pattern included in the first antenna structure 451 may be electrically connected to a power transmission/reception circuit disposed on the first printed circuit board 421. The power transmission/reception circuit may wirelessly receive power from an external electronic device or wirelessly transmit power to the external electronic device, by using the at least one conductive pattern. The power transmission/reception circuit may include a power management module, and for example, may include a power management integrated circuit (PMIC) or a charger integrated circuit (IC). The power transmission/reception circuit may charge the first battery 431 and/or the second battery 432 by using power wirelessly received using the conductive pattern.

According to an embodiment, the second antenna structure 452 may be positioned between the first support part 2111 of the first frame 211 and the first cover 212. The second antenna structure 452 may be disposed on a surface of the first inner support body 411, which faces the first cover 212, or on the first cover 212. The position of the second antenna structure 452 is not limited thereto, and may be various. For example, the second antenna structure 452 may be implemented in a film shape such as an FPCB. In an embodiment, a processor (e.g., the processor 120 in FIG. 1) electrically connected to a wireless communication circuit (e.g., the wireless communication module 192 in FIG. 1) may perform a positioning function (e.g., angle of arrival (AOA)) for a signal source (e.g., a responder, a transmitter, or a transmitter (Tx) device) by using the second antenna structure 452. The processor may simultaneously perform a positioning function (AOA) for measuring an angle, and a ranging function for measuring a distance. In an embodiment, the processor may identify (or estimate) the distance between the foldable electronic device 2 and the signal source by using at least one antenna element (e.g., a first antenna element, a second antenna element, and/or a third antenna element) included in the second antenna structure 452. In an embodiment, the processor may identify (or estimate) a reception angle (e.g., the direction of a signal) of a signal with respect to a set axis of the foldable electronic device 2 by using at least one of a difference in the arrival time of a response message for a request message through at least two antenna elements included in the second antenna structure 452, and an arrival distance difference or a phase difference between received signals. The foldable electronic device 2 may support a positioning function by using the bandwidth (e.g., an ultra-wide band (UWB)) of a broadband. For example, the UWB is a technology which conforms to the international standard of IEEE 802.15.4, and may be a technology for communicating using the bandwidth of a broadband. In an embodiment, the processor may identify or estimate a position of a signal source (e.g., a responder, a transmitter, or a Tx device) with respect to the foldable electronic device 2 (e.g., an initiator, a receiver, or a receiver (Rx) device) by using the phase difference between signals received through the multiple antenna elements included in the second antenna structure 452. The antenna structure 452 may be provided as a printed circuit board (e.g., a flexible printed circuit board (FPCB)), and for example, may be a patch antenna including multiple patches (e.g., a first antenna element, a second antenna element, and a third antenna element).

According to an embodiment, the third flexible printed circuit board 463 and/or the fourth flexible printed circuit board 464 may be disposed to cross the hinge part H. A third end 4631 of the third flexible printed circuit board 463 may include a third connector (e.g., a third FPCB connector), and a fourth end 4632 of the third flexible printed circuit board 463 may include a fourth connector (e.g., a fourth FPCB connector). The third connector may be electrically connected to an electrical element (e.g., the connector C3 of the first printed circuit board 421 in FIG. 10) positioned or accommodated in the first housing 21 (see FIG. 2). The fourth connector may be electrically connected to an electrical element (e.g., the connector C4 of the third printed circuit board 423 in FIG. 10) positioned or accommodated in the second housing 22 (see FIG. 2). A fifth end 4641 of the fourth flexible printed circuit board 464 may include a fifth connector (e.g., a fifth FPCB connector), and a sixth end 4642 of the fourth flexible printed circuit board 464 may include a sixth connector (e.g., a sixth FPCB connector). The fifth connector may be electrically connected to an electrical element (e.g., the connector C5 of the first printed circuit board 421 in FIG. 10) positioned or accommodated in the first housing 21 (see FIG. 2). The sixth connector may be electrically connected to an electrical element (e.g., the connector C6 of the third printed circuit board 423 in FIG. 10) positioned or accommodated in the second housing 22 (see FIG. 2). The third flexible printed circuit board 463 may have a film shape having a thickness between a third surface (not shown) and a fourth surface 463B (see FIG. 8) oriented in a direction opposite to the third surface, and may include signal lines (or electrical paths) for electrically connecting the third end 4631 and the fourth end 4632, and conductive patterns for configuring a ground area for reducing electromagnetic interference (EMI) on the signal lines. The fourth flexible printed circuit board 464 may have a film shape having a thickness between a fifth surface (not shown) and a sixth surface 464B (see FIG. 8) oriented in a direction opposite to the fifth surface, and may include signal lines (or electrical paths) for electrically connecting the fifth end 4641 and the sixth end 4642, and conductive patterns to configure a ground area for reducing electromagnetic interference (EMI) on the signal lines.

According to an embodiment, the first support part 2111 of the first frame 211 may include a first opening (or a first hole or a first through-hole) 501 (see FIGS. 5 and 6). The second support part 2211 of the second frame 221 may include a second opening (or a second hole or a second through-hole) 502 (see FIGS. 5 and 6). The third flexible printed circuit board 463 may extend through the first opening 501 and the second opening 502. In an embodiment, the first opening 501 and the second opening 502 may be overlapped and be aligned with each other in a folded state (see FIG. 3) of the foldable electronic device 2. The third flexible printed circuit board 463 may include a first fixation part F1, a second fixation part F2, and/or a third fixation part F3. The first fixation part F1, the second fixation part F2, and the third fixation part F3 may be provided in an area between the third end 4631 and the fourth end 4632 of the third flexible printed circuit board 463.

According to an embodiment, the first fixation part F1 of the third flexible printed circuit board 463 may be positioned between the first plate 71 and the first support part 2111 of the first frame 211. Through various coupling methods such as bonding including an adhesive material or a bonding material, or screw fastening, the first fixation part F1 may be coupled to the first plate 71 or the first support part 2111 of the first frame 211.

According to an embodiment, the second fixation part F2 of the third flexible printed circuit board 463 may be positioned between the second plate 72 and the second support part 2211 of the second frame 221. Through various coupling methods such as bonding including an adhesive material or a bonding material, or screw fastening, the second fixation part F2 may be coupled to the third plate 73 or the second support part 2211 of which is the second frame 221. When the foldable electronic device 2 is switched between an unfolded state and a folded state, the relative position between the first fixation part F1 and the second fixation part F2 may be changed, and the area between the first fixation part F1 and the second fixation part F2 of the third flexible printed circuit board 463 may be disposed in a shape corresponding to the relative position between the first fixation part F1 and the second fixation part F2. The hinge housing 23 may include a recess which contributes to that the area between the first fixation part F1 and the second fixation part F2 of the third flexible printed circuit board 463 is disposed while the stress thereof is reduced when the foldable electronic device 2 is switched between an unfolded state and a folded state.

According to an embodiment, the third fixation part F3 of the third flexible printed circuit board 463 may extend from an area between the third end 4631 and the first fixation part F1 of the third flexible printed circuit board 463. The third fixation part F3 may be disposed or coupled to the first support part 2111 of the first frame 211.

According to an embodiment, the first fixation part F1, the second fixation part F2, and/or the third fixation part F3 of the third flexible printed circuit board 463 may be configured to be less flexible (or more rigid) compared to other portions of the third flexible printed circuit board 463. The first fixation part F1, the second fixation part F2, and/or the third fixation part F3 may be substantially rigid. For example, the first fixation part F1 may include a first reinforcement part (or a first reinforcement member or a first reinforcement structure) such as a stiffener, and thus may be made rigid. For example, the second fixation part F2 may include a second reinforcement part (or a second reinforcement member or a second reinforcement structure) such as a stiffener, and thus may be made rigid. For example, the third fixation part F3 may include a third reinforcement part (or a third reinforcement member or a third reinforcement structure) such as a stiffener, and thus may be made rigid. In an embodiment, the first reinforcement part of the first fixation part F1 may include a screw hole for screw fastening with the first plate 71 or the first support part 2111 of the first frame 211. In an embodiment, the second reinforcement part of the second fixation part F2 may include a screw hole for screw fastening with the third plate 73or the second support part 2211 of the second frame 221. In various embodiments, the third flexible printed circuit board 463 may be implemented as a rigid flexible printed circuit board (rigid FPCB (RFPCB)), and the first fixation part F1, the second fixation part F2, or the third fixation part F3 may be substantially rigid without a reinforcement part.

According to an embodiment, the first support part 2111 of the first frame 211 may include a third opening (or a third hole or a third through-hole) 503 (see FIGS. 5 and 6). The second support part 4221 of the second frame 221 may include a fourth opening (or a fourth hole or a fourth through-hole) 504 (see FIGS. 5 and 6). The fourth flexible printed circuit board 464 may extend through the third opening 503 and the fourth opening 504. The third opening 503 and the fourth opening 504 may be overlapped and be aligned with each other in a folded state (see FIG. 3) of the foldable electronic device 2. The first opening 501 and the third opening 503 may be positioned to be spaced apart from each other in the direction (e.g., the y-axis direction) of the central line A of the foldable electronic device 2. The second opening 502 and the fourth opening 504 may be positioned to be spaced apart from each other in the direction of the central line A of the foldable electronic device 2. At least a part of the fourth flexible printed circuit board 464 may be configured to be identical or similar to the third flexible printed circuit board 463. The fourth flexible printed circuit board 464 may include a fourth fixation part F4 (e.g., the first fixation part F1) and a fifth fixation part F5 (e.g., the second fixation part F2) provided in the area between the fifth end 4641 and the sixth end 4642. Through various coupling methods such as bonding including an adhesive material or a bonding material, or screw fastening, the fourth fixation part F4 may be coupled to the second plate 72 or the first support part 2111 of the first frame 211. Through various coupling methods such as bonding including an adhesive material or a bonding material, or screw fastening, the fifth fixation part F5 may be coupled to the fourth plate 74 or the second support part 2211 of which is the second frame 221.

According to an embodiment, in a view from above the first cover 212, the first opening 501 may be positioned between the first battery 431 and the seventh bezel B7 (see FIG. 6). In a view from above the first cover 212, the third opening 503 may be positioned between the first printed circuit board 421 and the seventh bezel B7 (see FIG. 6).

According to an embodiment, in a view from above of the second display module 25, the second opening 502 and/or the fourth opening 504 may be positioned between the second battery 432 and the eighth bezel B8 (see FIG. 6). An area of the third flexible printed circuit board 463, which extends from the second fixation part F2 to the fourth end 4632, may be disposed in a bent shape to face the third printed circuit board 423, so that a fourth connector included in the fourth end 4632 of the third flexible printed circuit board 463 and the connector C4 disposed on the third printed circuit board 423 are connected while facing each other. An area of the fourth flexible printed circuit board 464, which extends from the fourth fixation part F4 to the sixth end 4642, may be disposed in a bent shape to face the third printed circuit board 423, so that a sixth connector included in the sixth end 4642 of the fourth flexible printed circuit board 464 and the connector C6 disposed on the third printed circuit board 423 are connected while facing each other.

According to an embodiment, in a view from above the first cover 212, the first flexible printed circuit board 461 may overlap the first battery 431. A third surface (e.g., a surface opposite to the fourth surface 463B in FIG. 8) of the third flexible printed circuit board 463 may face the first battery 431.

According to an embodiment, the fifth flexible printed circuit board 465 may electrically connect the first printed circuit board 421 and the second printed circuit board 422. For example, a connector module (e.g., a connector module corresponding to the connector hole 312 in FIG. 2) disposed on the second printed circuit board 422 may be electrically connected to the first printed circuit board 421 through the fifth flexible printed circuit board 465. In a view from above the first cover 212, the fifth flexible printed circuit board 465 may overlap the first battery 431.

According to an embodiment, the first flexible printed circuit board 461 may electrically connect the first printed circuit board 421 and the second printed circuit board 422. The first flexible printed circuit board 461 may include a first end 4611 including a first connector electrically connected to the first printed circuit board 421, and a second end 4612 including a second connector electrically connected to the second printed circuit board 422. The first flexible printed circuit board 461 may have a film shape having a thickness between a first surface (not shown) and a second surface 461B (see FIG. 10) oriented in a direction opposite to the first surface, and may include signal lines (or electrical paths) for electrically connecting the first end 4611 and the second end 4612, and conductive patterns for configuring a ground area for reducing electromagnetic interference (EMI) on the signal lines.

According to an embodiment, the first flexible printed circuit board 461 may be a flexible RF cable (FRC). The second printed circuit board 422 may include an antenna radiator, or may be electrically connected to the antenna radiator. A wireless communication circuit (e.g., the wireless communication module 192 in FIG. 1) may be disposed on the first printed circuit board 421. The wireless communication circuit may be electrically connected to the antenna radiator through the first flexible printed circuit board 461. The wireless communication circuit may transmit an emission current (or a wireless signal or an electromagnetic signal) to the antenna radiator through the first flexible printed circuit board 461. The wireless communication circuit may process a signal (or an RF signal) transmitted or received through an antenna radiator.

According to an embodiment, at least one conductive part included in the first side 2112 of the first frame 211 may be used as at least a part of an antenna radiator or radiation part which transmits electromagnetic waves (or electromagnetic signals) to the outside or receives electromagnetic waves from the outside. In an embodiment, the foldable electronic device 2 may include a first flexible conductive part (or a flexible conductive member) 422a (see FIG. 10) and/or a second flexible conductive part 422b (see FIG. 10) which are arranged on the second printed circuit board 422. The first flexible conductive part 422a and the second flexible conductive part 422b may be in elastic contact with the conductive part included in the first side 2112 of the first frame 211. The conductive part included in the first side 2112 of the first frame 211 may be electrically connected to the second printed circuit board 422 through the first flexible conductive part 422a and the second flexible conductive part 422b. The first flexible conductive part 422a or the second flexible conductive part 422b may be a conductive clip (e.g., a conductive structure including an elastic structure), but may be various such as a pogo pin, a spring, a conductive PORON, a conductive rubber, a conductive tape, or a conductive connector without being limited thereto. The second printed circuit board 422 may include a connector C2 electrically connected to the second end 4612 of the first flexible printed circuit board 461, and a conductive line (e.g., a signal line) for electrically connecting the first flexible conductive part 422a. The conductive part included in the first side 2112 of the first frame 211 may be electrically connected to a wireless communication circuit (e.g., the wireless communication module 192 in FIG. 1) disposed on the first printed circuit board 421 through the second printed circuit board 422 and the first flexible printed circuit board 461. The conductive part included in the first side 2112 of the first frame 211 may be electrically connected to a ground plane (or a ground area) included in the second printed circuit board 422 through the second flexible conductive part 422b. For example, the position or the portion of the conductive part included in the first side 2112, which is electrically connected to the first flexible conductive part 422a, may function as a feeding point (or a feeding part), and the position or the portion of the conductive part included in the first side 2112, which is electrically connected to the second flexible conductive part 422b, may function as a ground point. In case that a wireless communication circuit disposed on the first printed circuit board 421 provides (or feeds) an emission current to the feeding point, a signal path may be formed between the feeding point and the grounding point of the conductive part included in the first side 2112. The conductive part included in the first side 2112 may form an electrical length (e.g., a length expressed as a ratio of wavelengths) corresponding to the signal path so as to operate as an antenna radiator having a resonant frequency corresponding to the electrical length. In various embodiments, at least one conductive part included in the second side 2212 of the second frame 221 may be configured to operate as an antenna radiator in a substantially identical or similar manner thereto.

According to an embodiment, in a view from above the first cover 212, a partial area of the first flexible printed circuit board 461 may overlap the first battery 431. A part of the first surface (e.g., the surface of the first flexible printed circuit board 464, which is oriented in a direction opposite to the second surface 461B) of the first flexible printed circuit board 461 may face the first battery 431.

According to an embodiment, in a view from above the first cover 212, the first flexible printed circuit board 461 may not substantially overlap the third flexible printed circuit board 463.

According to various embodiments (not shown), in a view from above the first cover 212, the first flexible printed circuit board 461 may overlap the third flexible printed circuit board 463. In an embodiment, the portion, at which the first flexible printed circuit board 461 and the third flexible printed circuit board 463 overlap, may include a non-conductive member (e.g., a non-conductive film or a non-conductive sheet) (not shown) disposed between the first flexible printed circuit board 461 and the third flexible printed circuit board 463. A spaced distance between the first flexible printed circuit board 461 and the third flexible printed circuit board 463 may be provided by the non-conductive member, so as to reduce the electromagnetic influence (e.g., electromagnetic interference (EMI)) of the third flexible printed circuit board 463, on the first flexible printed circuit board 461. The non-conductive member may be disposed in an area of the first flexible printed circuit board 461, which faces the third flexible printed circuit board 463. In various embodiments, the non-conductive member may include a non-conductive adhesive material (or bonding material).

According to an embodiment, in a view from above the first cover 212, the first flexible printed circuit board 461 may not overlap the fourth flexible printed circuit board 464.

According to an embodiment, in a view from above the first cover 212, a partial area (hereinafter, a "first area") (a) of the first flexible printed circuit board 461 may be positioned between the first battery 431 and the seventh bezel B7 (see FIG. 6). In an embodiment, in an unfolded state (see FIG. 2) of the foldable electronic device 2, in a view from above the first cover 212, the first area (a) of the first flexible printed circuit board 461 may be positioned between the first battery 431 and the hinge housing 23.

According to an embodiment, the first area (a) of first flexible printed circuit board 461 may face the third support area 2111B (see FIG. 6) of the first support part 2111 included in the first frame 211. A part of the first surface (e.g., the surface of the first flexible printed circuit board 461, which is oriented in a direction opposite to the second surface 461B) of the first flexible printed circuit board 461, which is included in the first area (a), may face the third support area 2111B of the first support part 2111.

According to an embodiment, the first area (a) of the first flexible printed circuit board 461 may include a first portion area 1001 and a second portion area 1002. The first portion area 1001 may be connected to an area extending from the first area (a) to the first end 4611 of the first flexible printed circuit board 461. The second portion area 1002 may be connected to an area extending from the first area (a) to the second end 4612 of the first flexible printed circuit board 461. In a view from above the first cover 212, the first portion area 1001 may be positioned closer to the third bezel B3 than the fifth bezel B5, and the second portion area 1002 may be positioned closer to the fifth bezel B5 than the third bezel B3. In an embodiment, in a view from above the first cover 212, the second portion area 1002 may overlap an area including the first opening 501, through which the third flexible printed circuit board 463 extends, of the first support part 2111 of the first frame 211. The first portion area 1002 may have a first width W1. In an embodiment, in order to reduce the overlap between the second portion area 1002 and the first opening 501 in a view from above the first cover 212, the second portion area 1002 may have a second width W2 smaller than the first width W1. In a view from above the first cover 212, the first width W1 and the second width W2 may be widths in a direction orthogonal to the central line A of the foldable electronic device 2.

According to various embodiments, in a view from above the first cover 212, the second portion area 1002 may not substantially overlap the first opening 501.

According to an embodiment, the portion, at which the first flexible printed circuit board 461 and the third support area 2111B of the first support part 2111 overlap and face each other, may include a first non-conductive member (e.g., a non-conductive film or a non-conductive sheet) (e.g., the first non-conductive member 1210 in FIG. 12) disposed between the first flexible printed circuit board 461 and the third support area 2111B. The portion of the third support area 2111B, which faces and overlaps the first area (a) of the first flexible printed circuit board 461, may include a conductive material (or a metal material). A spaced distance between the third support area 2111B and the first area (a) may be provided by a first non-conductive member (e.g., the first non-conductive member 1210 in FIG. 12), so as to reduce the electromagnetic influence (e.g., the electromagnetic interference (EMI)) of the conductive material for providing the third support area 2111B, on the first area (a) of the first flexible printed circuit board 461. The first non-conductive member may be disposed on the first flexible printed circuit board 461. In various embodiments, the first non-conductive member may be disposed in the third support area 2111B. In various embodiments, the first non-conductive member may include a non-conductive adhesive material, and the first area (a) of the first flexible printed circuit board 461 may be coupled to the third support area 2111B of the first support part 2111.

According to an embodiment, in a view from above the first cover 212, the first area (a) of the first flexible printed circuit board 461 may overlap the third fixation part F3 of the third flexible printed circuit board 463. The third fixation part F3 may not include a conductive pattern such as a signal line or a ground plane. In case that the third flexible printed circuit board 463 is arranged on the first frame 211, the third fixation part F3 may function to guide the arrangement thereof. Since the third fixation part F3 does not substantially include a conductive material, it may be possible to reduce electromagnetic influence (e.g., electromagnetic interference) of the third fixation part F3, on the first area (a) of the first flexible printed circuit board 461.

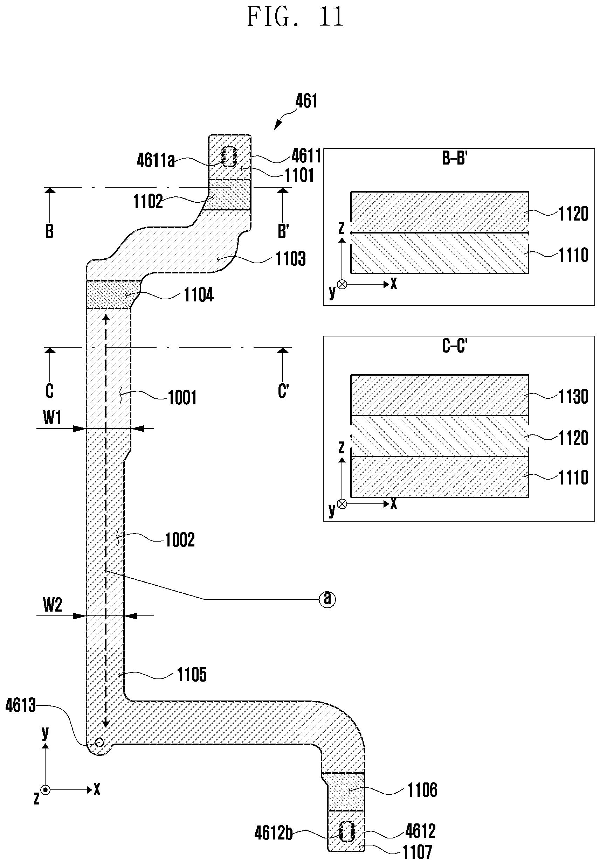

FIG. 11 shows a view of a first flexible printed circuit board 461, a cross-sectional view of the first flexible printed circuit board 461 cut along line B-B', and a cross-sectional view of the first flexible printed circuit board 461 cut along line C-C', according to an embodiment of the disclosure.

Referring to FIG. 11, in an embodiment, the first flexible printed circuit board 461 may include a first portion 1101, a second portion 1102, a third portion 1103, a fourth portion 1104, a fifth portion 1105, a sixth portion 1106, and/or a seventh portion 1107. The first portion 1101 may include a first end 4611 of the first flexible printed circuit board 461, in which a first connector 4611a is disposed. The second portion 1102 may be an area for connecting the first portion 1101 and the third portion 1103 of the first flexible printed circuit board 461. The third portion 1103 may be an area for connecting the second portion 1102 and the fourth portion 1104 of the first flexible printed circuit board 461. The fourth portion 1104 may be an area for connecting the third portion 1103 and the fifth portion 1105 of the first flexible printed circuit board 461. The fifth portion 1105 may be an area for connecting the fourth portion 1104 and the sixth portion 1106 of the first flexible printed circuit board 461. The sixth portion 1106 may be an area for connecting the fifth portion 1105 and the seventh portion 1107 of the first flexible printed circuit board 461. The seventh portion 1107 may include a second end 4612 of the first flexible printed circuit board 461, in which a second connector 4612a is disposed.

According to an embodiment, the first portion 1101, the third portion 1103, the fifth portion 1105, and/or the seventh portion 1107 may be less flexible than the second portion 1102, the fourth portion 1104, and/or the sixth portion 1106, or may be more rigid than the second portion 1102, the fourth portion 1104, and/or the sixth portion 1106. The first portion 1101, the third portion 1103, the fifth portion 1105, and/or the seventh portion 1107 may be substantially rigid, and the second portion 1102, the fourth portion 1104, and/or the sixth portion 1106 may be substantially flexible. In case that there is a height difference between the position at which the first portion 1101 is disposed in the foldable electronic device 2 and the position at which the third portion 1103 is disposed in the foldable electronic device 2, since the second portion 1102 is flexible, it may be possible to reduce stress (e.g., bending stress) generated in the second portion 1102. In case that there is a height difference between the position at which the third portion 1103 is disposed in the foldable electronic device 2 and the position at which the fifth portion 1105 is disposed in the foldable electronic device 2, since the fourth portion 1104 is flexible, it may be possible to reduce stress (e.g., bending stress) generated in the fourth portion 1104. In case that there is a height difference between the position at which the fifth portion 1105 is disposed in the foldable electronic device 2 and the position at which the seventh portion 1107 is disposed in the foldable electronic device 2, since the sixth portion 1106 is flexible, it may be possible to reduce stress (e.g., bending stress) generated in the sixth portion 1106. The position or the number of the flexible portions or the rigid portions included in the first flexible printed circuit board 461 is not limited to the illustrated example, and may be various.

According to an embodiment, for flexibility thereof, the second portion 1102, the fourth portion 1104, and/or the sixth portion 1106 may have a thickness thinner or a stacking number less than the first portion 1101, the third portion 1103, the fifth portion 1105, and/or the seventh portion 1107. In various embodiments, for flexibility thereof, the second portion 1102, the fourth portion 1104, and/or the sixth portion 1106 may include materials different from the first portion 1101, the third portion 1103, the fifth portion 1105, and/or the seventh portion 1107.

According to various embodiments, the first portion 1101, the third portion 1103, the fifth portion 1105, and/or the seventh portion 1107 may further include a reinforcement part (or a reinforcement member or a reinforcement structure) such as a stiffener and thus may become rigid, compared to the second portion 1102, the fourth portion 1104, or the sixth portion 1106. In various embodiments, the reinforcement part may include a film or a sheet.

According to an embodiment, the fifth portion 1105 may include the first area (a).

According to various embodiments, the first flexible printed circuit board 461 may be a rigid flexible printed circuit board.

According to an embodiment, the first flexible printed circuit board 461 may include multiple conductive layers including a conductive pattern and multiple non-conductive layers (e.g., insulation layers) stacked alternately with the multiple conductive layers. Some conductive patterns among the multiple conductive layers may be used as signal lines. Some conductive patterns among the multiple conductive layers may be used as ground planes (or ground areas).

According to various embodiments, the first flexible printed circuit board 461 may include multiple conductive vias. The conductive vias may be conductive holes penetrated to allow connection wires for electrically connecting conductive patterns of conductive layers different from each other to be arranged therethrough. For example, the conductive via may include a plated through-hole (PTH), a laser via hole (LVH), a buried via hole (BVH), or a stacked via. For example, at least one conductive via may be a part of a signal line, and may electrically connect signal line patterns arranged on layers different from each other. For example, at least one conductive via may electrically connect ground planes on different layers, and a conductive structure including ground planes and at least one conductive via for electrically connecting same may be defined or interpreted as the ground (or the ground structure) of the first flexible printed circuit board 461.

According to an embodiment, the first flexible printed circuit board 461 may include a first layer 1110, a second layer 1120, and/or a third layer 1130. The second layer 1120 may be disposed between the first layer 1110 and the third layer 1130. Although not illustrated herein, an insulating bonding material or adhesive material may be disposed between the first layer 1110 and the second layer 1120 and between the second layer 1130 and the third layer 1130. The first layer 1110, the second layer 1120, and/or the third layer 1130 may include a conductive pattern used as a signal line and/or a conductive pattern used as a ground plane. The second layer 1120 may be positioned between the first layer 1110 and the first cover 212 (see FIG. 2). The second portion 1102, the fourth portion 1104, and/or the sixth portion 1106 may include the first layer 1110 and the second layer 1120. The first portion 1101, the third portion 1103, the fifth portion 1105, and/or the seventh portion 1107 may include the first layer 1110, the second layer 1120, and the third layer 1130. In various embodiments, the number of the layers included in the first flexible printed circuit board 461 is not limited to the illustrated example, and may be various.

According to an embodiment, the fifth portion 1105 of the first flexible printed circuit board 461 may include a hole 4613 for fitting with the first support part 2111 (see FIG. 10) of the first frame 211. For example, the first support part 2111 (see FIG. 10) may include a protruding part inserted into the hole 4613 of the fifth portion 1105. The position or the number of the hole 4613 and the protruding part corresponding thereto is not limited to the illustrated example, and may be various. In various embodiments, in addition, the structure for stably fixing, disposing, or coupling the first flexible printed circuit board 461 to the first support part 2111 (see FIG. 10) of the first frame 211 may be various.

According to various embodiments, the hole 4613 of the fifth portion 1105 may be a screw hole for screw fastening, and the first support part 2111 may include a screw fastening part (e.g., a boss including a female screw) corresponding to the screw hole. The position or the number of screw holes is not limited to the illustrated example, and may be various.

FIG. 12 shows a view of a part of a foldable electronic device 2 in an unfolded state and a cross-sectional view of the foldable electronic device 2 cut along line D-D' (see FIGS. 10 and 12), according to an embodiment of the disclosure.

Referring to FIG. 12, the foldable electronic device 2 may include the first frame 211, the second frame 221, the first cover 212, the third hinge module 6, the hinge housing 23, the first display module 24, the second display module 25, the first printed circuit board 421, the third printed circuit board 423, the first battery 431, the second battery 432, the first antenna structure 451, the first flexible printed circuit board 461, the third flexible printed circuit board 463, a first non-conductive member 1210, and/or a flexible member 1220.

According to an embodiment, in a view from above the first cover 212, the first antenna structure 451 may overlap the first battery 431. A part of the third flexible printed circuit board 463 may be positioned between the first antenna structure 451 and the first battery 431.

According to an embodiment, in a view from above the second display module 25, the second printed circuit board 423 may be disposed in an area between the eighth bezel B8 and the second battery 432 of the second frame 221.

According to an embodiment, the first frame 211 may include a first connection area 1230 for connection with the first slider 61 of the third hinge module 6. The first connection area 1230 may be a part of the first lateral part 401 in FIG. 4, which corresponds to the third hinge module 6. The first connection area 1230 may include a recess 1231 into which the first slider 61 of the third hinge module 6 is inserted. Although not illustrated herein, the first connection area 1230 may include a screw fastening part (e.g., a boss including a female screw) for screw fastening with the first slider 61 of the third hinge module 6.

According to an embodiment, the first connection area 1230 may include a structure or a shape for connection with the first slider 61 of the third hinge module 6, and thus the first connection area 1230 of the first support part 2111 of the first frame 211 may be positioned closer to the first cover 212 than the first battery arrangement area 1251 (e.g., the area in which the first battery 431 is disposed) is positioned close thereto.

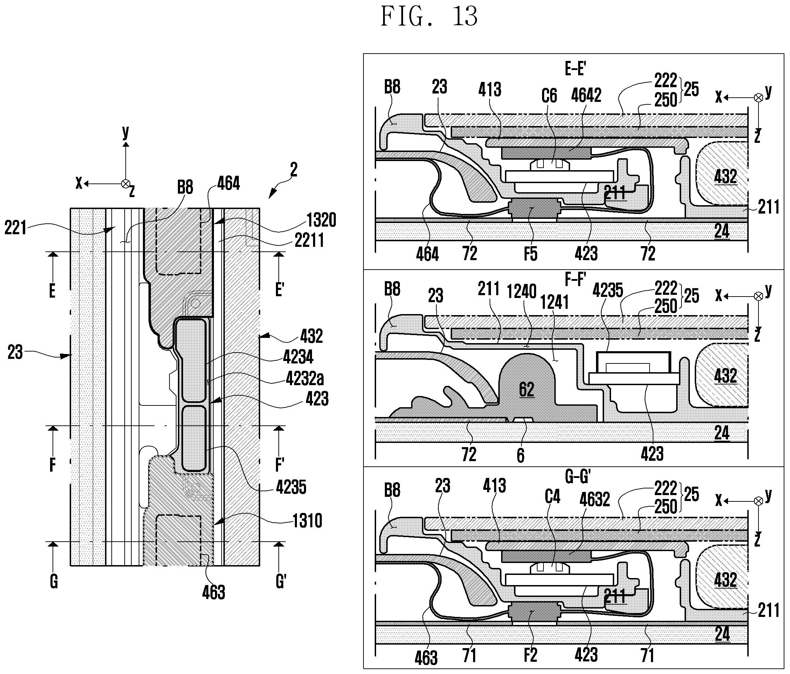

According to an embodiment, the second frame 221 may include a second connection area 1240 for connection with the second slider 62 of the third hinge module 6. The second connection area 1240 may be a part of the second lateral part 402 in FIG. 4, which corresponds to the third hinge module 6. The second connection area 1240 may include a recess 1241 (see FIG. 13) into which the second slider 62 of the third hinge module 6 is inserted. The second connection area 1240 may include a screw fastening part 1242 for screw fastening with the second slider 62 of the third hinge module 6.

According to an embodiment, the second connection area 1240 may include a structure or a form for connection with the second slider 62 of the third hinge module 6, and thus may be positioned closer to the second cover 222 or the second display module 25, compared to an area 1260 between the second connection area 1240 and the second battery arrangement area 1252 (e.g., the area in which the second battery 432 is disposed) of the second support part 2211 of the second frame 221.

According to an embodiment, in a view from above the second display module 25, a part 4232a of the second printed circuit board 423 may be provided in a shape (e.g., an avoidance shape) which does not overlap the second connection area 1240 of the second frame 221. A part (hereinafter, an "avoidance area") 4232a of the second printed circuit board 423 may be disposed in the area 1260 between the second connection area 1240 and the second battery arrangement area 1202 of the second support part 2211 of the second frame 221.

According to an embodiment, one or more electronic components 4233 may be arranged in the avoidance area 4232a of the second printed circuit board 423. One or more shielding members 4234 and 4235 may be arranged in the avoidance area 4232a of the second printed circuit board 423. For example, the shield member 4234 may reduce electromagnetic interference on the one or more electronic components 4233.

According to an embodiment, the first area (a) of the first flexible printed circuit board 461 may be disposed in an area (hereinafter, a "substrate support area") 1270 between the first battery arrangement area 1251 and the seventh bezel B7 of the first frame 211. In a view from above the first cover 212, the substrate support area 1270 may overlap the third hinge module 6 (or the first slider 61). A surface of the substrate support area 1270, on which the first area (a) of the first flexible printed circuit board 461 is disposed, may include a flat surface. The substrate support area 1270 may include a first connection area 1230 for connection with the first slider 61 of the third hinge module 6. The substrate support area 1270 may be included in the first lateral part 401 in FIG. 4.

According to an embodiment, the first non-conductive member 1210 may be disposed between the first area (a) of the first flexible printed circuit board 461 and the substrate support area 1270 of the first frame 211. A spaced distance between the substrate support area 1270 and the first area (a) may be provided by the first non-conductive member 1210, so as to reduce electromagnetic influence (e.g., electromagnetic interference (EMI)) of the conductive material (or a metal material) at least partially included in the substrate support area 1270, on the first area (a) of the first flexible printed circuit board 461. The first non-conductive member 1210 may be disposed in the first area (a) of the first flexible printed circuit board 461. The first non-conductive member 1210 may be disposed in the first substrate support area 1270 of the first frame 211. For example, the first non-conductive member 1210 may include a non-conductive film or a non-conductive sheet. In various embodiments, the first non-conductive member 1210 may include a non-conductive adhesive material. In various embodiments, the first non-conductive member 1210 may be a flexible member (e.g., a sponge) or a rigid member. In case that the first non-conductive member 1210 includes a flexible material or a buffer material, it may be possible to reduce that external impact is delivered to the first area (a) of the first flexible printed circuit board 461.

According to an embodiment, the flexible member 1220 may be disposed between the first cover 212 and the first area (a) of the first flexible printed circuit board 461. The flexible member 1220 may be disposed in the first area (a) of the first flexible printed circuit board 461. The flexible member 1220 may be disposed on the first cover 212. The flexible member 1220 may include a non-conductive material, so as to reduce electromagnetic influence (e.g., electromagnetic interference) on the first area (a) of the first flexible printed circuit board 461. In an embodiment, flexible member 1220 may be a sponge.

According to various embodiments, the flexible member 1220 may include a buffer material or a buffer member, and thus may reduce that external impact is delivered to the first area (a) of the first flexible printed circuit board 461.

According to various embodiments, the flexible member 1220 may include an adhesive material.

FIG. 13 shows a view of a part of a foldable electronic device 2, a cross-sectional view of the foldable electronic device 2 cut along line E-E', a cross-sectional view of the foldable electronic device 2 cut along line F-F', and a cross-sectional view of the foldable electronic device 2 cut along line G-G', according to an embodiment of the disclosure.

Referring to FIG. 13, in an embodiment, the foldable electronic device 2 may include the second frame 221, the first cover 212, the third hinge module 6, the hinge housing 23, the first plate 71, the second plate 72, the first display module 24, the second display module 25, the third printed circuit board 423, the second battery 432, the third flexible printed circuit board 463, the fourth flexible printed circuit board 464, and/or a third inner support body (e.g., a rear case) 413.

According to an embodiment, the third inner support body 413 may be positioned between the second support part 2211 of the second frame 221 and the second display module 25. The third inner support body 413 may be coupled to the second support part 2211. The third inner support body 413 may support the second display module 25.

According to an embodiment, the third inner support body 413 may cover a fourth end 4632 of the third flexible printed circuit board 463 and the sixth end 4642 of the fourth flexible printed circuit board 464. The third inner support body 413 may press the fourth end 4632 toward the connector C4 so that the fourth end 4632 of the third flexible printed circuit board 464 is not separated from the connector C4 of the third printed circuit board 423. The third inner support body 413 may press the sixth end 4642 toward the connector C6 so that the sixth end 4642 of the fourth flexible printed circuit board 464 is not separated from the connector C6 of the third printed circuit board 423.

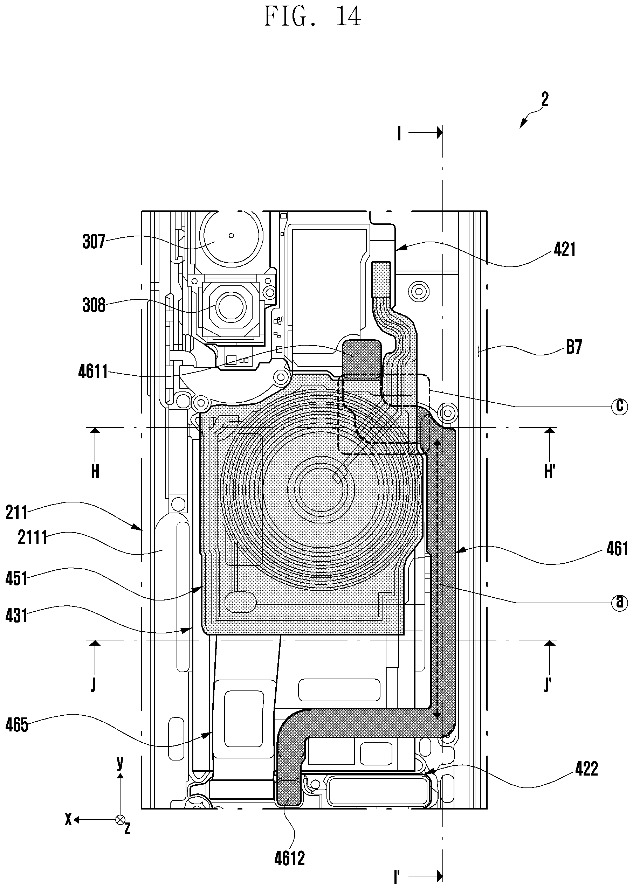

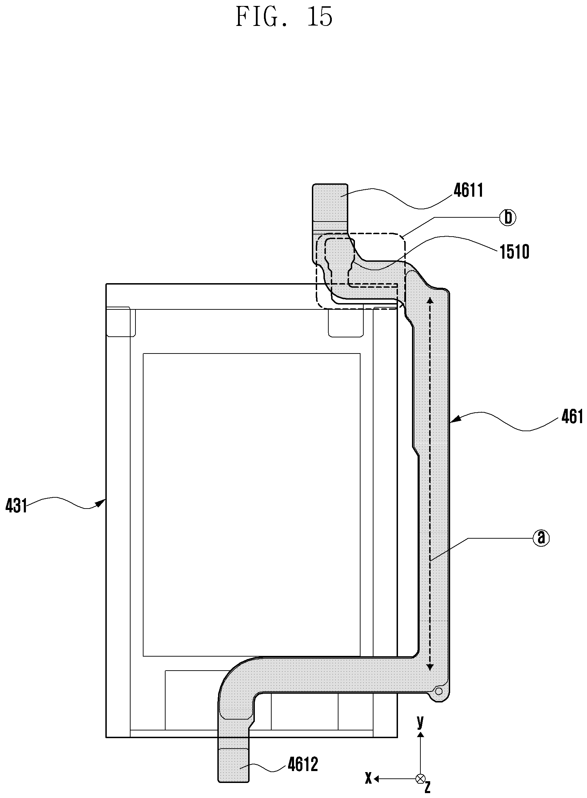

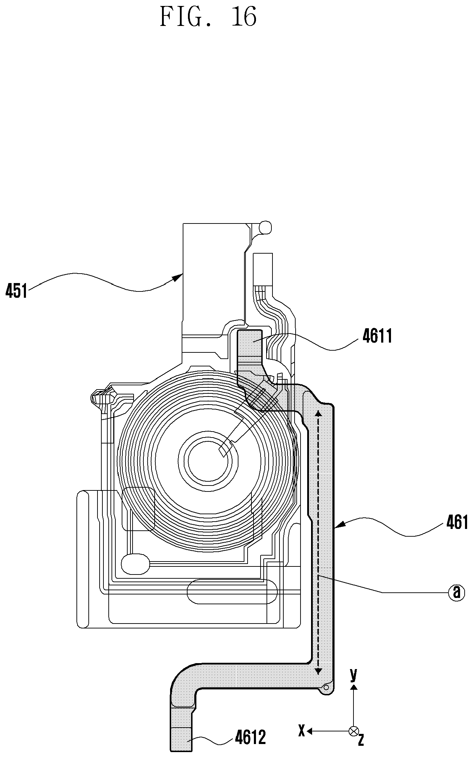

FIG. 14 is a view showing a part of a foldable electronic device 2 according to an embodiment of the disclosure. FIG. 15 is a view showing a first battery 431 and a first flexible printed circuit board 461 according to an embodiment of the disclosure. FIG. 16 is a view showing a first antenna structure 451 and a first flexible printed circuit board 461 according to an embodiment of the disclosure.

Referring to FIGS. 14, 15, and 16, the foldable electronic device 2 includes the first flexible printed circuit board 461. The foldable electronic device 2 may further include the first frame 211, the first printed circuit board 421, the first battery 431, the first printed circuit board 421, the second printed circuit board 422 and/or the first antenna structure 451.

According to an embodiment, in a view from above the first cover 212 (see FIG. 2), the first antenna structure 451 may overlap the first battery 431. In various embodiments, the foldable electronic device 2 may further include a non-conductive support body (or support member or support structure) at least partially positioned between the first antenna structure 451 and the first battery 431, and the non-conductive support body may support the first antenna structure 451.

According to an embodiment, in a view from above first cover 212 (see FIG. 2), the first flexible printed circuit board 461 may overlap the first battery 431.

According to an embodiment, the foldable electronic device 2 may include a second flexible printed circuit board (e.g., a battery FPCB) 1510 for electrically connecting the first battery 431 and the first printed circuit board 421. The second flexible printed circuit board 1510 may extend from the first battery 431. In various embodiments, the second flexible printed circuit board 1510 may be defined or interpreted as a part of the first battery 431.

According to an embodiment, in a view from above the first cover 212 (see FIG. 2), the first flexible printed circuit board 461 may include the second area ⓑ overlapped with the second flexible printed circuit board 1510. An area of the first flexible printed circuit board 461, which extends from the first area ⓐ to the first end 4611, may include the second area ⓑ positioned between the second flexible printed circuit board 1510 and the first cover 212 (see FIG. 2).

According to an embodiment, in a view from above the first cover 212 (see FIG. 2), the first flexible printed circuit board 461 may include the third area ⓒ overlapping the first antenna structure 451. A partial area of the first antenna structure 451 may be positioned between an area of the first flexible printed circuit board 461, which extends from the first area ⓐ to the first end 4611, and the first cover 212 (see FIG. 2). In an embodiment, the second area ⓑ and the third area ⓒ of the first flexible printed circuit board 461 may include at least a portion of an area identical to each other.

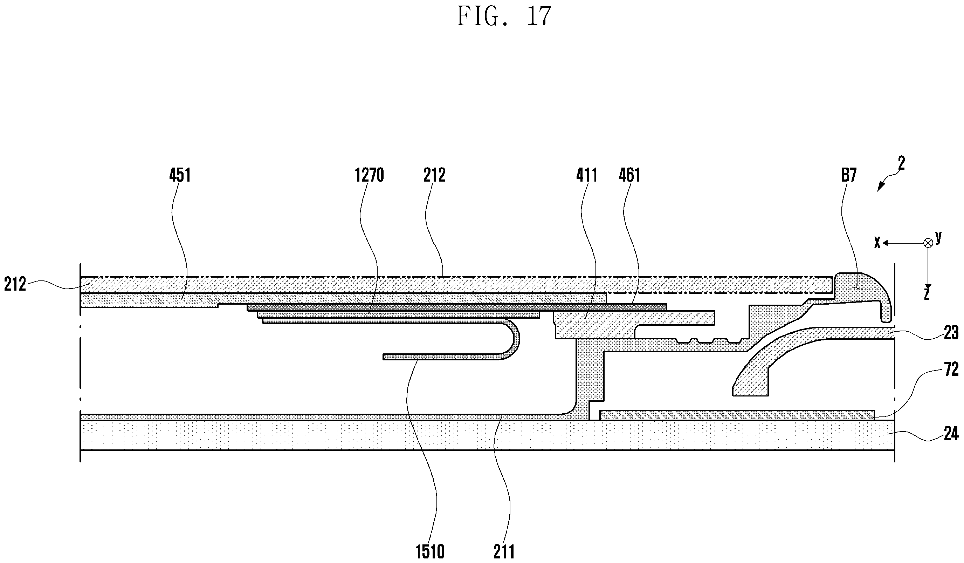

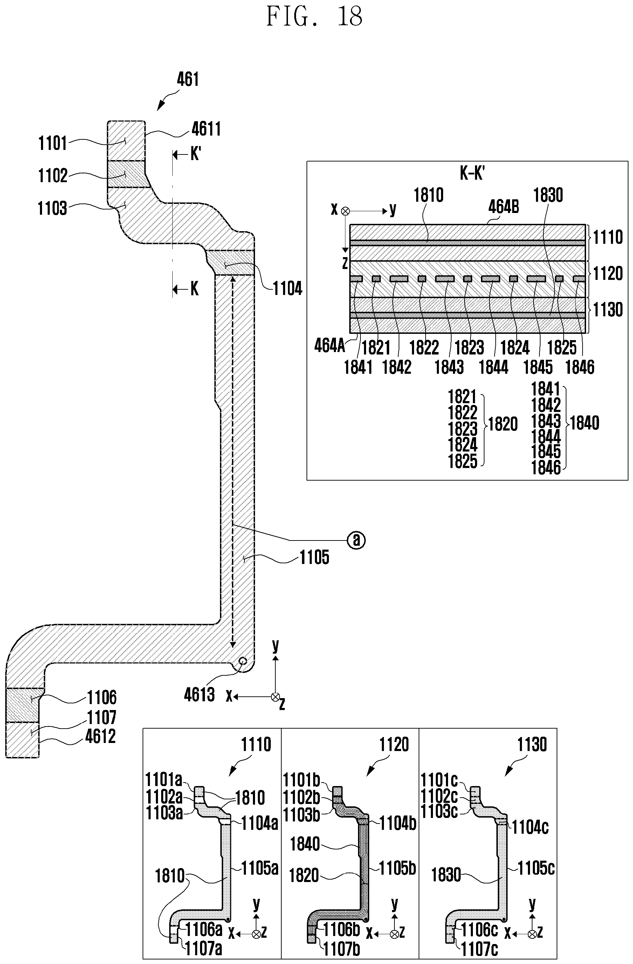

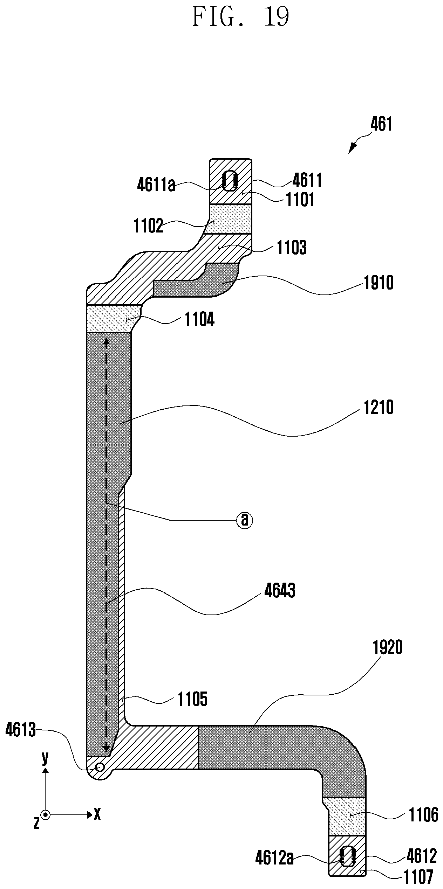

FIG. 17 is a cross-sectional view showing a foldable electronic device 2 cut along line H-H' in FIG. 14 according to an embodiment of the disclosure. FIG. 18 shows a view of a first flexible printed circuit board 461 and a cross-sectional view of the first flexible printed circuit board 461 cut along line K-K', according to an embodiment of the disclosure. FIG. 19 is a view showing a first flexible printed circuit board 461 according to an embodiment of the disclosure.

Referring to FIGS. 17, 18, and 19, the foldable electronic device 2 may include the first frame 211, the hinge housing 23, the first frame 211, the second plate 72, the first display module 24, the first inner support body 411, the first antenna structure 451, the first flexible printed circuit board 461, the second flexible printed circuit board (e.g., a battery FPCB) 1510, the first non-conductive member 1210, a second non-conductive member 1910, and/or a third non-conductive member 1920.

According to an embodiment, in a view from above the first cover 212, the first flexible printed circuit board 461 may overlap the first antenna structure 451. In a view from above the first cover 212, the first flexible printed circuit board 461 may overlap the first flexible printed circuit board 1510. In an embodiment, in a view from above the first cover 212, an area of the first flexible printed circuit board 461, which extends from the first area (a) to the first end 4611, or the third portion 1103 of the first flexible printed circuit board 461 may overlap the first antenna structure 451 and/or the second flexible printed circuit board 1510.

According to an embodiment, the third area ⓒ (see FIG. 14) (e.g., the third portion 1103) of the first flexible printed circuit board 461, which overlaps the first antenna structure 451, may include a first layer 1110, a second layer 1120, and a third layer 1130. The second layer 1120 may be disposed between the first layer 1110 and the third layer 1130. The first layer 1110 may be disposed between the second layer 1120 and the first cover 212. The first layer 1110 may include an area 1101a included in the rigid first portion 1101 (see FIG. 11), an area 1103a included in the rigid third portion 1103 (see FIG. 11), an area 1105a included in the rigid fifth portion 1105 (see FIG. 11), and/or an area 1107a included in the rigid seventh portion 1107 (see FIG. 11). The first layer 1110 may include an empty area 1102a between the two areas 1101a and 1103c, an empty area 1104a between the two areas 1103c and 1105a, and/or an empty area 1106a between the two areas 1105a and 1107a. The second layer 1120 may include an area 1101b included in the rigid first portion 1101 (see FIG. 11), an area 1102b included in the flexible second portion 1102 (see FIG. 11), an area 1103b included in the rigid third portion 1103 (see FIG. 11), an area 1104b included in the flexible fourth portion 1104 (see FIG. 11), an area 1105b included in the rigid fifth portion 1105 (see FIG. 11), an area 1106b included in the flexible sixth portion 1106 (see FIG. 11), and/or an area 1107b included in the rigid seventh portion 1107 (see FIG. 11). The third layer 1130 may include an area 1101c included in the rigid first portion 1101 (see FIG. 11), an area 1102c included in the flexible second portion 1102 (see FIG. 11), an area 1103c included in the rigid third portion 1103 (see FIG. 11), an area 1104c included in the flexible fourth portion 1104 (see FIG. 11), an area 1105c included in the rigid fifth portion 1105 (see FIG. 11), an area 1106c included in the flexible sixth portion 1106 (see FIG. 11), and/or an area 1107c included in the rigid seventh portion 1107 (see FIG. 11).

According to an embodiment, multiple signal lines 1820 (e.g., the first signal line 1821, the second signal line 1822, the third signal line 1823, the fourth signal line 1824, and/or the fifth signal line 1825) may be included in the second layer 1120. The third layer 1130 may include a ground plane 1830. The ground plane 1830 of the third layer 1130 may be positioned between the first antenna structure 451 and the third area ⓒ (see FIG. 14) of the first flexible printed circuit board 464, which overlaps the first antenna structure 451. The ground plane 1830 of the third layer 1130 may reduce or shield the electromagnetic influence (e.g., electromagnetic interference (EMI)) of the first antenna structure 451 or the fifth flexible printed circuit board 1510, on the multiple signal lines 1820.

According to an embodiment, the first layer 1110 may include a ground plane 1810. The ground plane 1810 of the first layer 1110 may be electrically connected to a ground plane 1830 of the third layer 1130. For example, the ground plane 1810 of the first layer 1110 and the ground plane 1830 of the third layer 1130 may be electrically connected through one or more vias included in the first flexible printed circuit board 461. The ground plane 1810 of the first layer 1110 may reduce or shield the electromagnetic influence (e.g., electromagnetic interference) of external noise traveling from the outside toward the first cover 212, on the multiple signal lines 1820. The ground plane 1810 of the first layer 1110, the ground plane 1830 of the third layer 1130, and a current carrying structure (e.g., one or more vias) between the ground planes 1810 and 1830 may become a ground structure which at least partially surrounds the multiple signal lines 1820. The ground structure may reduce or shield electromagnetic interference on the multiple signal lines 1820.

According to an embodiment, the second layer 1120 may further include a ground plane 1840. The ground plane 1840 may include multiple ground areas 1841, 1842, 1843, 1844, 1845, and 1846. The one ground area 1841 may be positioned on one lateral part of the first flexible printed circuit board 461. Another ground area 1846 may be positioned on the other lateral part of the first flexible printed circuit board 461. Each of the remaining ground areas 1842, 1843, 1844, and 1845 may be positioned between the two signal lines. The ground plane 1840 of the second layer 1120 may be electrically connected to the ground plane 1810 of the first layer 1110 and the ground plane 1830 of the third layer 1130. For example, the ground plane 1840 of the second layer 1120 may be electrically connected to the ground plane 1810 of the first layer 1110 and/or the ground plane 1830 of the third layer 1130 through one or more vias included in the first flexible printed circuit board 461. The ground plane 1810 of the first layer 1110, the ground plane 1830 of the third layer 1130, the ground plane 1840 of the second layer 1120, and a current carrying structure (e.g., one or more vias) between the multiple ground planes 1810, 1830, and 1840 may become a ground structure which at least partially surrounds the multiple signal lines 1820. The ground structure may reduce or shield electromagnetic interference on the multiple signal lines 1820.

According to various embodiments, the number of the layers included in the first flexible printed circuit board 461, the position or the number of the signal lines included in the first flexible printed circuit board 461, or the position, the number, or the shape of the ground plane is not limited to the illustrated example, and may be various.

The first flexible printed circuit board 461includes a first surface 461A and a second surface 461B oriented in a direction opposite to the first surface 461A. In an embodiment, the first surface 461A of the first flexible printed circuit board 461 may substantially face the first display area ① (see FIG. 2) of the first display module 24, and the second surface 461B of the first flexible printed circuit board 461 may substantially face the first cover 212 (see FIG. 2). The second surface 461B may be provided by the first layer 1110 or provided by a non-conductive material layer (e.g., a coating layer or a protective layer) disposed on the first layer 1110. The first surface 461A may be provided by the third layer 1130 or provided by a non-conductive material layer (e.g., a coating layer or a protective layer) disposed on the third layer 1130.

According to various embodiments, the first flexible printed circuit board 461 may further include a conductive member (e.g., a conductive sheet, a conductive film, or a conductive coating layer) disposed on the first layer 1110 or the third layer 1130. The conductive member (e.g., a conductive sheet, a conductive film, or a conductive coating layer) may be disposed on the first surface 461A or the second surface 461B. The conductive member (e.g., a shield member) may be electrically connected to a ground structure included in the first flexible printed circuit board 461. The conductive member may reduce or shield electromagnetic interference on the multiple signal lines 1821, 1822, 1823, 1824, and 1825. In an embodiment, the conductive member disposed on the first surface 461A or the second surface 461B of the first flexible printed circuit board 461 may be a graphite sheet or a graphite layer.

According to an embodiment, in a view from above the first cover 212 (see FIG. 2), at least a part of an area of the first flexible printed circuit board 461 (or at least a part of an area, which does not overlap the first antenna structure 451, of the first area (a), and/or the first flexible printed circuit board 461 (or the first area ((a))), which overlaps the substrate support area 1270 (see FIG. 17) may be implemented such that the multiple signal lines are included in the first layer 1110. For example, at least part of an area, which overlaps the substrate support area 1270 (see FIG. 17) while not overlapping the first antenna structure 451, of the first flexible printed circuit board 461 may be implemented such that the multiple signal lines are included in the first layer 1110. In various embodiments, at least a part of an area, which extends from the first area (a) to the first end 4611, of the first flexible printed circuit board 461 may be implemented such that the multiple signal lines are included in the first layer 1110.

According to an embodiment, in a view from above the first cover 212, the second non-conductive member 1910 may be at least partially disposed in an area (e.g., the second area ⓑ in FIG. 14) of the first flexible printed circuit board 461, which overlaps the fifth flexible printed circuit board 1510. The second non-conductive member 1910 may be positioned between the first flexible printed circuit board 461 and the fifth flexible printed circuit board 1510. The second non-conductive member 1910 may be disposed on the first surface 461A of the first flexible printed circuit board 461. For example, the second non-conductive member 1910 may include a non-conductive film, a non-conductive sheet, or a non-conductive coating layer. A spaced distance between the first flexible printed circuit board 461 and the second flexible printed circuit board 1510 may be provided by the second non-conductive member 1910, so as to reduce the electromagnetic influence (e.g., electromagnetic interference (EMI)) of the second flexible printed circuit board 1510, on the first flexible printed circuit board 461.

According to various embodiments, a conductive member (e.g., a conductive sheet, a conductive film, or a conductive coating layer) may replace the second non-conductive member 1910, and the conductive member may be electrically connected to a ground structure included in the first flexible printed circuit board 461. For example, the conductive member may include a graphite sheet or graphite layer.

According to an embodiment, the third non-conductive member 1920 may be disposed in an area of the first flexible printed circuit board 461, which extends from the first area (a) to the second end 4612. The third non-conductive member 1920 may be disposed on the first surface 461A of the first flexible printed circuit board 461. For example, the third non-conductive member 1920 may include a non-conductive film, a non-conductive sheet, or a non-conductive coating layer. A spaced distance between the first flexible printed circuit board 461 and the conductive element may be provided by the third non-conductive member 1920, so as to reduce the electromagnetic influence (e.g., electromagnetic interference (EMI)) of a conductive element (e.g., various electrical elements such as the battery 431 in FIG. 10) of the foldable electronic device 2, which is overlapped with the third non-conductive member 1920, on the first flexible printed circuit board 461.

According to various embodiments, a conductive member (e.g., a conductive sheet, a conductive film, or a conductive coating layer) may replace the third non-conductive member 1920, and the conductive member may be electrically connected to a ground structure included in the first flexible printed circuit board 461. For example, the conductive member may include a graphite sheet or graphite layer.

According to various embodiments, a conductive member (e.g., a conductive sheet, a conductive film, or a conductive coating layer) may replace the first non-conductive member 1210, and the conductive member may be electrically connected to a ground structure included in the first flexible printed circuit board 461. For example, the conductive member may include a graphite sheet or graphite layer.

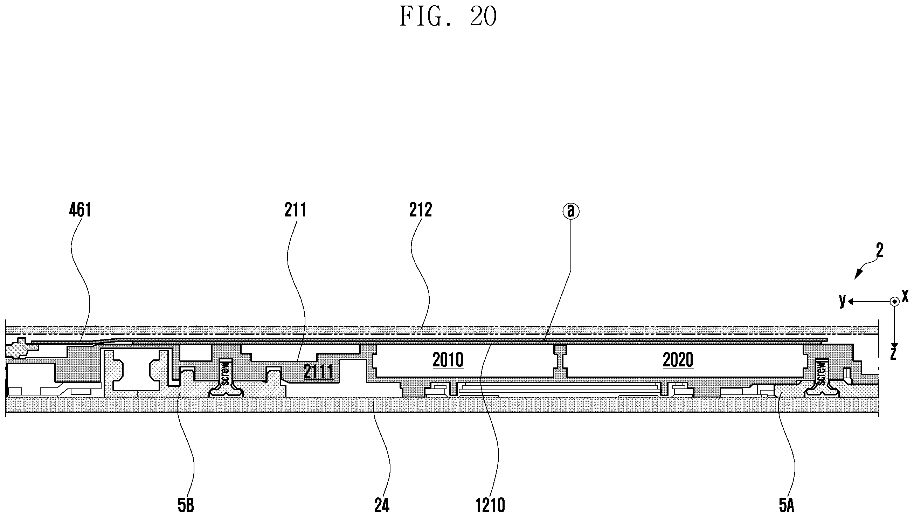

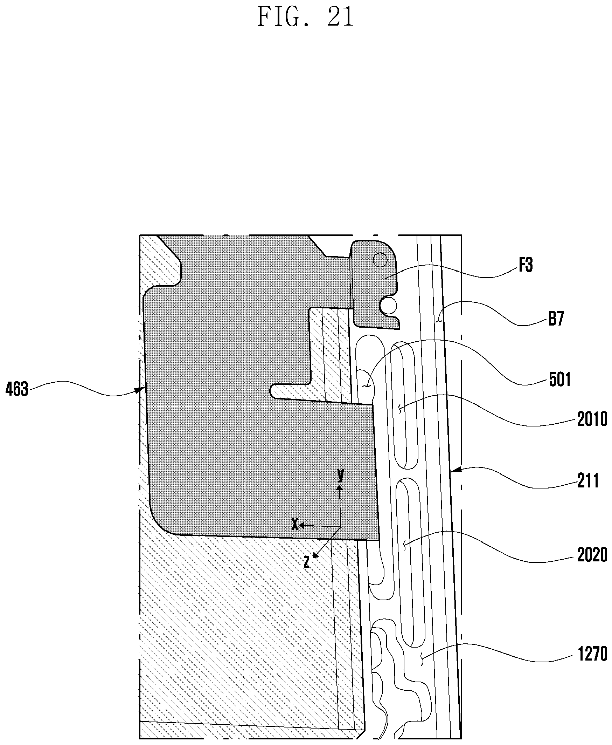

FIG. 20 is a cross-sectional view showing a foldable electronic device 2 cut along line I-I' in FIG. 14 according to an embodiment of the disclosure. FIG. 21 is a perspective view showing a part of a foldable electronic device 2 according to an embodiment of the disclosure.

Referring to FIGS. 20 and 21, the foldable electronic device 2 may include the first frame 211, the first hinge module 5A, the second hinge module 5B, the first cover 212, the first display module 24, the first battery 431, and/or the third printed circuit board 463.

According to one embodiment, the substrate support area 1270 included in the first support part 2111 of the first frame 211 may include one or more recesses 2010 and 2020. The one or more recesses 2010 and 2020 may reduce the electromagnetic influence (e.g., electromagnetic interference (e.g., electromagnetic interference (EMI)) of the substrate support area 1270 made of metal or a conductive material included in the substrate support area 1270, on the first area ⓐ (see FIG. 14) of the first flexible printed circuit board 461. In various embodiments, the one or more recesses 2010 and 2020 may be replaced with an opening (or a through-hole).

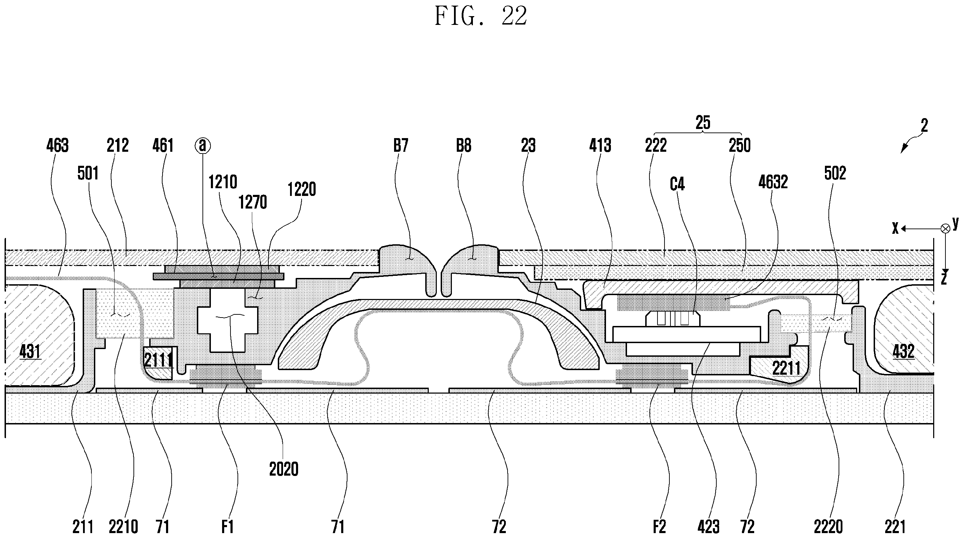

FIG. 22 is a cross-sectional view showing a foldable electronic device 2 cut along line J-J' in FIG. 14 according to an embodiment of the disclosure.

Referring to FIG. 22, the foldable electronic device 2 may include the first frame 211, the second frame 221, the hinge housing 23, the first plate 71, the second plate 72, the first cover 212, the first display module 24, the second display module 25, the third printed circuit board 423, the first battery 431, the second battery 432, the first flexible printed circuit board 461, the third flexible printed circuit board 463, the first non-conductive member 1210, the flexible member 1220, a first seal part 2210, and/or a second seal part 2220.

According to an embodiment, the first seal part (seal portion) (or a first waterproof part, a first waterproof member, a first seal member, or a first seal material) 2210 may be arranged in the first opening 501 of the first frame 211. The second seal part (or a second waterproof part, a second waterproof member, a second seal member, or a second seal material) 2220 may be arranged in the second opening 502 of the second frame 221. Although not illustrated herein, a third seal part (or a third waterproof part, a third waterproof member, a third seal member, or a third seal material) may be disposed in the third opening 503 (see FIG. 5) of the first frame 211. Although not illustrated herein, a fourth seal part (or, a fourth waterproof part, a fourth waterproof member, a fourth seal member, or a fourth seal material) may be disposed in the fourth opening 504 (see FIG. 5) of the second frame 221. In an embodiment, the first seal part 2210, the second seal part 2220, the third seal part, or the fourth seal part may be formed after filling an adhesive material (e.g., a cured in place gasket (CIPG)) therein and then by curing (e.g., curing through a light reaction or a heat reaction) the filled adhesive material. The first seal part 2210 may reduce or prevent that foreign substances such as moisture or dust move through the first opening 501. The second seal part 2220 may reduce or prevent that foreign substances such as moisture or dust move through the second opening 502. The third seal part may reduce or prevent that foreign substances such as moisture or dust move through the third opening 503 (see FIG. 5). The fourth seal part may reduce or prevent that foreign substances such as moisture or dust move through the fourth opening 504 (see FIG. 5).

According to an embodiment, the third flexible printed circuit board 463 may extend through the first seal part 2210 disposed in the first opening 501 and the second seal part 2220 disposed in the second opening 502. The third flexible printed circuit board 463 may be connected to the first frame 211 through the first seal part 2210, and may be connected to the second frame 221 through the second seal part 2220. The fourth flexible printed circuit board 464 (see FIG. 4) may extend through the third seal part disposed in the third opening 503 (see FIG. 5) and the fourth seal part disposed in the fourth opening 504 (see FIG. 5). The fourth flexible printed circuit board 464 (see FIG. 4) may be connected to the first frame 211 through the third seal part, and may be connected to the second frame 221 through the fourth seal part.

According to an embodiment, the recess 2020 included in the substrate support area 1270 included in the first frame 211 may reduce the electromagnetic influence (e.g., electromagnetic interference (EMI)) of the substrate support area 1270 made of metal or a conductive material included in the substrate support area 1270, on the first area (a) of the first flexible printed circuit board 461.

According to an exemplary embodiment of the disclosure, a foldable electronic device 2 may include a foldable housing 20, a flexible display module (e.g., the first display module 24), a first flexible printed circuit board 461, and a first non-conductive member 1210. The foldable housing 20 may include a first housing 21, a second housing 22, and a hinge part H configured to connect the first housing 21 and the second housing 22. The flexible display module (e.g., the first display module 24) may include a first display area ①, a second display area ②, and a third display area ③. The first display area ① may be disposed in the first housing 21. The second display area ② may be disposed in the second housing 22. The third display area ③ may be positioned to correspond to the hinge part H. The third display area ③ may correspond between the first display area ① and the second display area ② of the flexible display module 24. The first flexible printed circuit board 461 may be accommodated in the first housing 20. The first flexible printed circuit board 461 may include a first surface 461A facing the first display area ① and a second surface 461B oriented in a direction opposite to the first surface 461A. The first non-conductive member 1210 may be disposed between the first surface 461A of the first flexible printed circuit board 461 and the first housing 21. The first housing 21 may include a first lateral part 401 connected to the hinge part H. The first lateral part 401 may include a metal material. The second housing 22 may include a second lateral part 402 connected to the hinge part H. In a view from above the second surface 461B, the first flexible printed circuit board 461 may include a first area ⓐ configured to face and overlap the first lateral part 401. The first non-conductive member 1210 may be disposed between the first area (a) and the first lateral part 401. Thus, the first flexible printed circuit board 461 is disposed by utilizing a part connected to a hinge part H, among the first housing 21, in a limited space inside the foldable electronic device 2, thereby improving space efficiency, and the electromagnetic influence exerted on the first flexible printed circuit board 461 by the part connected to the hinge part H is reduced by the non-conductive member 1210 thereby securing the integrity of signals transferred through the first flexible printed circuit board 461.

According to an exemplary embodiment of the disclosure, the foldable electronic device 2 further may comprise a third flexible printed circuit board 463 accommodated in the foldable housing 20 and disposed to cross the hinge part H. In a view from above the second surface 461B the first area (a) overlaps the third flexible printed circuit board 463. Thus, the first flexible printed circuit board 461 is disposed by utilizing a part connected to a hinge part H, among the first housing 21, in a limited space inside the foldable electronic device 2, thereby improving space efficiency.

According to an exemplary embodiment of the disclosure, the foldable electronic device 2 may comprise a non-conductive member disposed between the first flexible printed circuit board 461 and the third flexible printed circuit board 463 at a portion where the first flexible printed circuit board 461 and the third flexible printed circuit board 463 overlap. Thus, a spaced distance between the first flexible printed circuit board 461 and the third flexible printed circuit board 463 may be provided by the non-conductive member, so as to reduce the electromagnetic influence (e.g., electromagnetic interference (EMI)) of the third flexible printed circuit board 463, on the first flexible printed circuit board 461.

According to an exemplary embodiment of the disclosure, the foldable electronic device 2 further may comprise a fourth flexible printed circuit board 464 accommodated in the foldable housing 20 and disposed to cross the hinge part H. In a view from above the second surface 461B, the first flexible printed circuit board 461 does not overlap the fourth flexible printed circuit board 464. Thus, since in a view from above the second surface 461B, the fourth flexible printed circuit board 464 is spaced from the first flexible printed circuit board 461, the electromagnetic influence (e.g., electromagnetic interference (EMI)) of the fourth flexible printed circuit board 464 on the first flexible printed circuit board 461 is reduced.

According to an exemplary embodiment of the disclosure, the hinge part H may include a first hinge module 5A, a second hinge module 5B, and a third hinge module 6. The third hinge module 6 may be positioned between the first hinge module 5A and the second hinge module 5B. In a view from above the second surface 461B, the first area (a) may overlap the third hinge module 6. In an unfolded state of the foldable electronic device 2, the first hinge module 5A, the second hinge module 5B, the third hinge module 6, the first plate 71, and the second plate 72 may reduce or prevent the sagging phenomenon or the crease phenomenon of the third display area ③ while providing space efficient integration in limited space.

According to an exemplary embodiment of the disclosure, the foldable electronic device 2 may further include a third flexible printed circuit board 463 and a fourth flexible printed circuit board 464. The third flexible printed circuit board 463 may be accommodated in the foldable housing 20, and may be disposed to cross a portion between the first hinge module 5A and the third hinge module 6 of the hinge part H. The fourth flexible printed circuit board 464 may be accommodated in the foldable housing 20, and may be disposed to cross a portion between the second hinge module 5B and the third hinge module 6 of the hinge part H. Thus, the third and fourth flexible printed circuit boards 463, 464 are disposed by utilizing a part connected to a hinge part H, among the first housing 21, in a limited space inside the foldable electronic device 2, thereby improving space efficiency.

According to an exemplary embodiment of the disclosure, the first flexible printed circuit board 461 may be an FRC.

According to an exemplary embodiment of the disclosure, the first housing 21 may include a first frame 211 and a first cover 212 disposed on the first frame 211. The first frame 211 may include a first side 2112 and a first support part 2111. The first side 2112 may be configured to surround at least a part of the space between the first display area ① and the first cover 212. The first support part 2111 may be positioned in the space between the first display area ① and the first cover 212 and connected to the first side 2112. The first support part 2111 may be positioned between the first display area ① and the first flexible printed circuit board 461. A conductive part included in the first side 2122 may be electrically connected to a wireless communication circuit (e.g., the wireless communication module 192 in FIG. 1) accommodated in the first housing 21 through the first flexible printed circuit board 461. Thus, through the first flexible printed circuit board 461, the wireless communication circuit may process a signal (or an RF signal) transmitted or received through an antenna radiator.

According to an exemplary embodiment of the disclosure, the foldable electronic device 2 may further include a first printed circuit board 421, a second printed circuit board 422, and a battery 431 which are accommodated in the first housing 21. In a view from above the second surface 461B, the battery 431 may be positioned between the first printed circuit board 421 and the second printed circuit board 422. The first printed circuit board 421 and the second printed circuit board 422 may be electrically connected through the first flexible printed circuit board 461. In a view from above the second surface 461B, the first area (a) may be positioned to be spaced apart from the battery 431. Thus, since in a view from above the second surface 461B, the battery 431 is spaced from the first flexible printed circuit board 461, the electromagnetic influence (e.g., electromagnetic interference (EMI)) of the battery 431 on the first flexible printed circuit board 461 is relatively reduced.

According to an exemplary embodiment of the disclosure, the foldable electronic device 2 may further include a second non-conductive member 1910 disposed on the first flexible printed circuit board 461, and a battery 431 accommodated in the first housing 21 and a second flexible printed circuit board 1510 extending from the battery 431. In a view from above the second surface 461B, the first flexible printed circuit board 461 may include a second area ⓑ configured to overlap the second flexible printed circuit board 1510. The second non-conductive member 1910 may be positioned between the second area ⓑ and the second flexible printed circuit board 1510. Since a spaced distance between the first flexible printed circuit board 461 and the second flexible printed circuit board 1510 is provided by the second non-conductive member 1910, the electromagnetic influence (e.g., electromagnetic interference (EMI)) of the second flexible printed circuit board 1510, on the first flexible printed circuit board 461 is reduced.

According to an exemplary embodiment of the disclosure, the foldable electronic device 2 may further include an antenna structure (e.g., the first antenna structure 451) accommodated in the first housing 21. The antenna structure may include a coil. In a view from above the second surface 461B, the first flexible printed circuit board 461 may include a third area ⓒ configured to overlap the antenna structure. The third area ⓒ may include a first layer 1110, a third layer 1130, and a second layer 1120 positioned between the first layer 1110 and the third layer 1130. The second layer 1120 may include multiple signal lines. The first layer 1110 may include a ground plane 1810. The third layer 1130 may include a ground plane 1830. Thus, the ground plane 1810 of the first layer 1110 reduces or shields the electromagnetic influence (e.g., electromagnetic interference) of external noise traveling from the outside on the multiple signal lines 1820. The ground plane 1810 of the first layer 1110 and the ground plane 1830 of the third layer 1130 may become a ground structure which at least partially surrounds the multiple signal lines 1820 to reduce or shield electromagnetic interference on the multiple signal lines 1820.

According to an exemplary embodiment of the disclosure, the first lateral part 401 may include one or more recesses (2010 and 2020) or openings provided in a portion of the first lateral part 401, which overlaps the first area ⓐ. The one or more recesses 2010 and 2020 reduce the electromagnetic influence (e.g., electromagnetic interference (EMI)) of the first lateral part 401 including metal or a conductive material on the first area ⓐ of the first flexible printed circuit board 461.

According to an exemplary embodiment of the disclosure, the first flexible printed circuit board 461 includes one or more rigid portions (e.g., the first portion 1101, the third portion 1103, the fifth portion 1105, and the seventh portion 1107), and one or more flexible portions (e.g., the second portion 1102, the fourth portion 1104, and the sixth portion 1106). The first area ⓐ may be included in the one or more rigid portions. Thus, in case that there is a height difference between positions at which rigid portions are disposed in the foldable electronic device 2, due to the one or more flexible portions, it is be possible to reduce stress (e.g., bending stress) generated in the portions between the rigid portions.

According to an exemplary embodiment of the disclosure, the foldable electronic device 2 may further include a flexible member 1220 disposed on the second surface 461B to correspond to the first area (a). Since the flexible member 1220 is disposed in the second surface 461B to correspond to the first area (a), an external impact may be reduced that is delivered to the first area (a) of the first flexible printed circuit board 461.

According to an exemplary embodiment of the disclosure, the hinge part H may include a hinge housing 23. When the foldable housing 20 is switched from an unfolded state to a folded state, the hinge housing 23 may be exposed to the outside through an open gap between the first lateral part 401 and the second lateral part 402. Thus, since the hinge housing 23 becomes a part of the exterior which covers the inside of the foldable electronic device 2 exposed through the open gap between the first housing 21 and the second housing 22 an optical appearance can be maintained also in the folded state.

According to an exemplary embodiment of the disclosure, the foldable electronic device 2 may include a foldable housing 20, a flexible display module (e.g., the first display module 24), a first flexible printed circuit board 461, a third flexible printed circuit board 463, and a first non-conductive member 1210. The foldable housing 20 may include a first housing 21, a second housing 22, and a hinge part H configured to connect the first housing 21 and the second housing 22. The flexible display module (e.g., the first display module 24) may include a first display area ①, a second display area ②, and a third display area ③. The first display area ① may be disposed in the first housing 21. The second display area ② may be disposed in the second housing 22. The third display area ③ may be positioned to correspond to the hinge part H. The third display area ③ may correspond between the first display area ① and the second display area ② of the flexible display module 24. The first flexible printed circuit board 461 may be accommodated in the first housing 20 and may include a first surface 461A facing the first display area ① and a second surface 461B oriented in a direction opposite to the first surface 461A. The third flexible printed circuit board 463 may be accommodated in the foldable housing 20 and disposed to cross the hinge part H. The first non-conductive member 1210 may be disposed between the first surface 461A of the first flexible printed circuit board 461 and the first housing 21. The first housing 21 may include a first lateral part 401 connected to the hinge part H. The first lateral part 401 may include a metal material. The second housing 22 may include a second lateral part 402 connected to the hinge part H. In a view from above the second surface 461B, the first flexible printed circuit board 461 may include a first area ⓐ configured to face and overlap the first lateral part 401. The first non-conductive member 1210 may be disposed between the first area (a) and the first lateral part 401. When viewed from above the second surface 461B, the first area (a) may overlap the third flexible printed circuit board 463. Thus, the first flexible printed circuit board 461 is disposed by utilizing a part connected to a hinge part H, among the first housing 21, in a limited space inside the foldable electronic device 2, thereby improving space efficiency, and the electromagnetic influence exerted on the first flexible printed circuit board 461 by the part connected to the hinge part H is reduced by the non-conductive member 1210 thereby securing the integrity of signals transferred through the first flexible printed circuit board 461.

According to an exemplary embodiment of the disclosure, the first flexible printed circuit board 461 may be an FRC.

According to an exemplary embodiment of the disclosure, the foldable electronic device 2 may further include a second non-conductive member 1910 disposed on the first flexible printed circuit board 461, and a battery 431 accommodated in the first housing 21 and a second flexible printed circuit board 1510 extending from the battery 431. In a view from above the second surface 461B, the first flexible printed circuit board 461 may include a second area ⓑ configured to overlap the second flexible printed circuit board 1510. The second non-conductive member 1910 may be positioned between the second area ⓑ and the second flexible printed circuit board 1510.

According to an exemplary embodiment of the disclosure, the foldable electronic device 2 may further include an antenna structure (e.g., the first antenna structure 451) accommodated in the first housing 21. The antenna structure may include a coil. In a view from above the second surface 461B, the first flexible printed circuit board 461 may include a third area ⓒ configured to overlap the antenna structure. The third area ⓒ may include a first layer 1110, a third layer 1130, and a second layer 1120 positioned between the first layer 1110 and the third layer 1130. The second layer 1120 may include multiple signal lines. The first layer 1110 may include a ground plane 1810. The third layer 1130 may include a ground plane 1830.

According to an exemplary embodiment of the disclosure, the first lateral part 401 may include one or more recesses (2010 and 2020) or openings provided in a portion of the first lateral part 401, which overlaps the first area ⓐ.

Embodiments disclosed in the disclosure and the drawings are merely specific examples presented to easily describe the technical content and to help understanding of embodiments, and are not intended to limit the scope of embodiments. Accordingly, in connection with a scope of various embodiments of the disclosure, the scope of various embodiments of the disclosure should be interpreted to include not only embodiments disclosed herein but also changed or modified forms thereof.

## Claims

1. A foldable electronic device (2) comprising:
a foldable housing (20) comprising a first housing (21), a second housing (22), and a hinge part (H) connecting the first housing (21) and the second housing (22);
a flexible display module (24) comprising a first display area (①) disposed in the first housing (21), a second display area (②) disposed in the second housing (22), and a third display area (③) positioned between the first display area (①) and the second display area (@) to correspond to the hinge part (H);
a first flexible printed circuit board (461) which is accommodated in the first housing (21) and comprises a first surface (461A) facing the first display area (①) and a second surface (461B) oriented in a direction opposite to the first surface (461A); and
a first non-conductive member (1210) disposed between the first surface (461A) of the first flexible printed circuit board (461) and the first housing (21),
wherein the first housing (21) comprises a first lateral part (401) connected to the hinge part (H) and comprising a metal material,
wherein the second housing (22) comprises a second lateral part (402) connected to the hinge part (H),
wherein in a view from above the second surface (461B), the first flexible printed circuit board (461) comprises a first area (@) facing and overlapping the first lateral part (401), and
wherein the first non-conductive member (1210) is disposed between the first area (@) and the first lateral part (401).

2. The electronic device of claim 1, further comprising a third flexible printed circuit board (463) accommodated in the foldable housing (20) and disposed to cross the hinge part (H), and
wherein in a view from above the second surface (461B), the first area (@) overlaps the third flexible printed circuit board (463).

3. The electronic device of claim 2, further comprising a non-conductive member disposed between the first flexible printed circuit board (461) and the third flexible printed circuit board (463) at a portion where the first flexible printed circuit board (461) and the third flexible printed circuit board (463) overlap.

4. The electronic device of any one of the claims 1 to 3, further comprising a fourth flexible printed circuit board (464) accommodated in the foldable housing (20) and disposed to cross the hinge part (H), wherein in a view from above the second surface (461B), the first flexible printed circuit board (461) does not overlap the fourth flexible printed circuit board (464).

5. The electronic device of any one of the claims 1 to 4, wherein the hinge part (H) comprises a first hinge module (5A), a second hinge module (5B), and a third hinge module (6),
wherein the third hinge module (6) is positioned between the first hinge module (5A) and the second hinge module (5B), and
wherein in a view from above the second surface (461B), the first area (@) overlaps the third hinge module (6).

6. The electronic device of claim 5, wherein the third flexible printed circuit board (463) is disposed to cross a portion between the first hinge module (5A) and the third hinge module (6) of the hinge part (H); and/or
the fourth flexible printed circuit board (464) is disposed to cross a portion between the second hinge module (5B) and the third hinge module (6) of the hinge part (H).

7. The electronic device of any one of claims 1 to 6, wherein the first flexible printed circuit board (461) comprises a flexible RF cable (FRC).

8. The electronic device of any one of claims 1 to 7, wherein the first housing (21) comprises a first frame (211) and a first cover (212) disposed on the first frame (211),
wherein the first frame (211) comprises a first side (2112) configured to surround at least a part of a space between the first display area (①) and the first cover (212), and a first support part (2111) positioned in the space and connected to the first side (2112),
wherein the first support part (2111) is positioned between the first display area (①) and the first flexible printed circuit board (461), and
wherein a conductive part included in the first side (2122) is electrically connected to a wireless communication circuit (192) accommodated in the first housing (21) through the first flexible printed circuit board (461).

9. The electronic device of any one of claims 1 to 8, further comprising a first printed circuit board (421), a second printed circuit board (422), and a battery (431) which are accommodated in the first housing (21),
wherein in a view from above the second surface (461B), the battery (431) is positioned between the first printed circuit board (421) and the second printed circuit board (422),
wherein the first printed circuit board (421) and the second printed circuit board (422) are electrically connected through the first flexible printed circuit board (461), and
wherein in a view from above the second surface (461B), the first area (@) is positioned to be spaced apart from the battery (431).

10. The electronic device of any one of claims 1 to 8, further comprising:
a second non-conductive member (1910) disposed on the first flexible printed circuit board (461); and
a battery (431) accommodated in the first housing (21) and a second flexible printed circuit board (1510) extending from the battery (431),
wherein in a view from above the second surface (461B), the first flexible printed circuit board (461) comprises a second area (ⓑ) overlapping the second flexible printed circuit board (1510), and
wherein the second non-conductive member (1910) is positioned between the second area (ⓑ) and the second flexible printed circuit board (1510).

11. The electronic device of any one of claims 1 to 10, further comprising an antenna structure (451) accommodated in the first housing (21) and comprising a coil,
wherein in a view from above the second surface (461B), the first flexible printed circuit board (461) comprises a third area (ⓒ) overlapping the antenna structure (451),
wherein the third area (ⓒ) comprises a first layer (1110), a third layer (1130), and a second layer (1120) positioned between the first layer (1110) and the third layer (1130),
wherein the second layer (1120) comprises multiple signal lines,
wherein the first layer (1110) comprises a ground plane (1810), and
wherein the third layer (1130) comprises a ground plane (1830).

12. The electronic device of any one of claims 1 to 11, wherein the first lateral part (401) comprises one or more recesses (2010; 2020) or openings provided in a portion of the first lateral part (401), which overlaps the first area (ⓐ).

13. The electronic device of any one of claims 1 to 12, wherein the first flexible printed circuit board (461) comprises one or more rigid portions (1101, 1103, 1105, and 1107) and one or more flexible portions (1102, 1104, and 1106), and
wherein the first area (@) is included in the one or more rigid portions (1101, 1103, 1105, and 1107).

14. The electronic device of any one of claims 1 to 13, further comprising a flexible member (1220) disposed on the second surface (461B) to correspond to the first area (ⓐ).

15. The electronic device of any one of claims 1 to 14, wherein the hinge part (H) comprises a hinge housing (23), and
wherein in a folded state of the foldable housing (20), the hinge housing (23) is exposed to the outside through an open gap between the first lateral part (401) and the second lateral part (402).
